# EUROPÄISCHE PATENTSCHRIFT

(11) **EP 2 780 200 B1**
(45) Veröffentlichungstag und Bekanntmachung des Hinweises auf die Patenterteilung: **21.02.2018**
(21) Anmeldenummer: 12794887.5
(22) Anmeldetag: 02.11.2012
(51) Int. Cl.: H02K 5/22, H02K 11/00

(54) **GEHÄUSE UND BAUSATZ FÜR EINE STEUERUNGSVORRICHTUNG**
HOUSING AND CONSTRUCTION KIT FOR A CONTROL APPARATUS
BOÎTIER ET KIT POUR DISPOSITIF DE COMMANDE

(30) Priorität: 15.11.2011 DE 102011055349
(43) Veröffentlichungstag der Anmeldung: 24.09.2014
(73) Patentinhaber: Brose Fahrzeugteile GmbH & Co. Kommanditgesellschaft, Bamberg, 96052 Bamberg (DE)
(72) Erfinder: ROSENTHAL, Karl-Heinz, 96148 Baunach (DE); KEIM, Sascha, 96269 Großheirath (DE)
(74) Vertreter: Maikowski & Ninnemann Patentanwälte Partnerschaft mbB
(86) Internationale Anmeldenummer: PCT/EP2012/071730
(87) Internationale Veröffentlichungsnummer: WO 2013/072202

(56) Entgegenhaltungen:
- WO-A2-2008/046832
- DE-A1- 10 108 414
- DE-A1- 19 851 455
- DE-C1- 10 141 246
- US-A1- 2005 013 095
- US-B1- 6 317 332

## Beschreibung

Die vorliegende Erfindung betrifft unter anderem ein Gehäuse nach dem Oberbegriff des Anspruches 1.

Ein solches Gehäuse ist aus der DE 101 41 246 C1 bekannt und für ein elektronisches Steuergerätemodul ausgebildet und vorgesehen, wobei das Steuergerätemodul, als Teil einer Steuerungsvorrichtung, zur Steuerung einer Antriebseinheit, insbesondere einer Kraftfahrzeugverstelleinrichtung, wie z. B. ein Fensterheber, dient. Das Gehäuse nimmt dabei üblicherweise wenigstens eine Leiterplatte des Steuergerätemoduls schützend in seinem Inneren auf.

Gerade im Kraftfahrzeugbereich werden unterschiedliche Steuergeräte bereitgestellt, die sich je nach Anordnung der zu steuernden Antriebseinheit innerhalb des Kraftfahrzeugs voneinander unterscheiden. So werden in der Praxis bisher unterschiedliche Formen von Leiterplatten in Abhängigkeit davon eingesetzt, ob die damit gebildete Steuerungsvorrichtung in einem Nass- oder Trockenraum oder auf der linken Fahrzeugseite oder der rechten Fahrzeugseite des Kraftfahrzeugs angeordnet werden soll. Unterschiedliche Typen von Steuergerätemodulen, z. B. für die linke Fahrzeugseite einerseits und die rechte Fahrzeugseite andererseits, weisen hier regelmäßig unterschiedliche geometrische Formen und Abmessungen in den Leiterplatten auf.

Dementsprechend muss eine Vielzahl von unterschiedlichen Gehäusen bereitgestellt werden, die jeweils für einen Typ von Steuergerätemodul ausgestaltet ist.

So wird bisher insbesondere ein Steuergerät, das in dem Trockenraum einer linken Kraftfahrzeugtür zur Steuerung eines Fensterhebers ausgebildet und vorgesehen ist, mit seinem zugehörigen Gehäuse konstruktiv unterschiedlich zu einem Steuergerät mit zugehörigem Gehäuse ausgelegt, das in dem Trockenraum einer rechten Kraftfahrzeugtür zur Steuerung eines Fensterhebers ausgebildet und vorgesehen ist.

Darüber hinaus unterscheiden sich derzeit auch Gehäuse und Leiterplatten eines Steuergeräts, das in einem Nassraum einer Kraftfahrzeugtür anzuordnen ist, von dem Steuergerät und der Leiterplatte eines Steuergeräts, das in einem Trockenraum einer Kraftfahrzeugtür anzuordnen ist. Dies ist insbesondere dem Umstand geschuldet, dass die auf der Leiterplatte angeordneten elektronischen Bauelemente bei einem in einem Nassraum anzuordnenden Steuergerät besser vor eventuell eindringender Feuchtigkeit zu schützen sind. Die Leiterplatte muss daher üblicherweise nahezu vollständig in einem gegenüber dem Außenraum abgedichteten Inneren des Gehäuses zumindest teilweise aufgenommen sein und somit in einem Gehäuse, das konstruktiv verschiedenartig ausgebildet wird als ein Gehäuse für einen Trockenraum.

Mit den unterschiedlichen Komponenten für eine Steuervorrichtung zum Steuern einer Antriebseinheit, die alle je nach Anwendung und Typ der Steuervorrichtung variieren, ist aber insbesondere ein hoher logistischer Aufwand verbunden, da alle unterschiedlichen Komponenten vorgehalten werden müssen. Ferner müssen mehrere zur Herstellung der einzelnen, unterschiedlichen Komponenten vorgesehene Werkzeuge bereitgestellt werden und auch die einzelnen Komponenten untereinander aufwändig abgestimmt werden.

Es ist daher Aufgabe der vorliegenden Erfindung, eine Möglichkeit bereitzustellen, Steuervorrichtungen zur Steuerung einer Antriebseinheit, insbesondere einer Antriebseinheit für eine Kraftfahrzeugverstelleinrichtung mit unterschiedlichen Ausstattungsvarianten und für unterschiedliche Anbringungsorte möglichst kostengünstig und einfach herzustellen.

Diese Aufgabe wird insbesondere mit einem Gehäuse gemäß dem Anspruch 1 oder dem Anspruch 2 gelöst.

Das Gehäuse des Anspruchs 1 ist dabei dazu ausgebildet und vorgesehen, wahlweise wenigstens die Leiterplatte eines von wenigstens zwei unterschiedlichen Typen von Steuergerätemodulen mit unterschiedlichen Leiterplatten zumindest teilweise aufzunehmen, wobei ein erster Typ von Steuergerätemodul für die Steuerung einer Antriebseinheit auf einer ersten Seite eines Kraftfahrzeugs eingerichtet und vorgesehen ist und ein zweiter Typ von Steuergerätemodul für die Steuerung von Antriebseinheit auf einer zweiten Seite des Kraftfahrzeugs, die der ersten Seite quer zu einer Fahrzeuglängsachse gegenüberliegt, eingerichtet und vorgesehen ist. Mit anderen Worten, wird ein Gehäuse bereitgestellt, das wahlweise die Leiterplatte eines Steuergerätemoduls teilweise oder vollständig in seinem Inneren aufnimmt und zwar unabhängig davon, ob das Steuergerätemodul für eine Antriebseinheit auf einer ersten (z. B. linken) Fahrzeugseite oder der gegenüberliegenden (rechten) Fahrzeugseite eingerichtet und vorgesehen ist.

Das Gehäuse weist hierbei folglich z. B. einen derart dimensionierten Innenraum auf, dass wahlweise je nach Typ des gewählten Steuergerätemoduls entweder die eine oder die andere Leiterplatte des jeweiligen Steuergerätemoduls in dem Gehäuse gelagert werden kann. Vorzugsweise weist das Gehäuse hier Abschnitte, wie z. B. Gehäuseöffnungen, auf, die entweder für die Unterbringung der einen Leiterplatte oder für die Unterbringung der anderen Leiterplatte vorgesehen sind. Das Gehäuse ist demgemäß so ausgebildet, dass es sowohl die Spezifikationen für die Anordnung eines Steuergerätemoduls eines ersten Typs als auch die Spezifikationen für ein Steuergerätemodul eines zweiten Typs erfüllt. Auf diese Weise muss nur noch ein Gehäuse bereitgestellt werden, um durch Kombination mit einem Steuergerätemodul entweder des ersten oder des zweiten Typs eine Steuerungsvorrichtung für entweder die rechte oder die linke Fahrzeugseite montieren zu können.

Eine Kopplung eines Steuergerätemoduls mit der zu steuernden Antriebseinheit wird über einen (Motor-) Steckverbinder bereitgestellt, der mit der Leiterplatte verbunden und gegebenenfalls sogar an dieser angeordnet ist. Das in dem Gehäuse zumindest teilweise aufgenommene Steuergerätemodul kann somit in einfacher Weise mit einem korrespondierenden Anschluss einer Antriebseinheit der Verstelleinrichtung verbunden werden. Die Verbindung des Steuergerätemoduls mit einem übergeordneten Steuersystem wird üblicherweise gleichfalls über einen (weiteren) Steckverbinder realisiert, an den beispielsweise ein Kabel angeschlossen werden kann.

Mindestens eine an dem Gehäuse vorgesehene Gehäuseöffnung ist dabei so ausgebildet, dass durch diese hindurch jeweils ein mit dem Steckverbinder verbundener Abschnitt der Leiterplatte aus dem Gehäuse herausgeführt werden kann. Dieser herausgeführte Abschnitt steht in einem Ausführungsbeispiel zapfenförmig bzw. fingerartig von einem vorzugsweise rechteckförmigen Basisabschnitt der Leiterplatte ab. Dieser Abschnitt ist hier dann zur Einführung in ein Gehäuse der zu steuernden Antriebseinheit, vorzugsweise in ein Motorgehäuse der Antriebseinheit, einführbar.

An diesem herausgeführten, vorzugsweise fingerartig ausgebildeten Abschnitt ist bevorzugt, wenigstens ein Sensorelement, beispielsweise ein Hall-Sensor angeordnet. Dieses Sensorelement steht somit über den herausgeführten Abschnitt der Leiterplatte im zusammengebauten Zustand an dem Gehäuse einer Steuerungsvorrichtung hervor. Das Sensorelement kann damit bei Verbindung des Gehäuses der Steuerungsvorrichtung mit einem Gehäuse der Antriebseinheit in einfacher Weise in das Gehäuse der Antriebseinheit eingeführt werden.

Gemäß einem weiteren Aspekt der vorliegenden Erfindung, der auch bei einem Gehäuse des Anspruchs 1 Anwendung finden kann, ist vorgesehen, dass ein Gehäuse für ein elektronisches Steuergerätemodul wenigstens zwei Gehäuseöffnungen aufweist, in der jeweils ein Steckverbinder eines Steuergerätemoduls gehalten werden kann und dass das Gehäuse dazu ausgebildet und vorgesehen ist, wahlweise wenigstens die Leiterplatte und den mindestens einen Steckverbinder eines von wenigstens zwei unterschiedlichen Typen von Steuergerätemodulen zumindest teilweise so aufzunehmen, dass der Steckverbinder eines ersten Typs von Steuergerätemodul in der einen Gehäuseöffnung und der Steckverbinder des zweiten Typs von Steuergerätemodul in der anderen Gehäuseöffnung gehalten wird.

Es wird hier folglich ein Gehäuse vorgegeben, das Gehäuseöffnungen sowohl für einen Steckverbinder eines Steuergerätemoduls eines ersten Typs als auch für einen Steckverbinder eines Steuergerätemoduls eines zweiten Typs beinhaltet. Ein solches Gehäuse kann somit auch bei zwei unterschiedlichen Steuergerätemodulen Verwendung finden, bei denen zum Anschluss an eine zu steuernde Antriebseinheit vorgesehene Motorsteckverbinder an unterschiedlichen Stellen des Gehäuses angeordnet sind, wenn das jeweilige Steuergerätemodul mit seiner zugehörigen Leiterplatte in dem Gehäuse zumindest teilweise aufgenommen ist. Ein Beispiel hierfür sind die bereits obig angesprochenen Steuergerätemodule, die je nach Anbringung in der linken oder rechten Fahrzeughälfte konstruktiv verschiedenartig ausgebildet sind und bei denen insbesondere ein mit der Leiterplatte verbundener oder an dieser angeordneter Motorsteckverbinder an einer anderen Stelle in Bezug auf das Gehäuse zu platzieren ist. Durch die Ausbildung zweier voneinander räumlich beabstandeter Gehäuseöffnungen an einem Gehäuse für derart unterschiedliche Typen von Steuergerätemodulen kann somit ein einzelnes Gehäuse zur Herstellung von sich konstruktiv und gegebenenfalls auch funktionell unterscheidenden Steuerungsvorrichtungen genutzt werden.

Hierbei ist in einem bevorzugten Ausführungsbeispiel auch vorgesehen, dass das Gehäuse auch für unterschiedliche Ausstattungsvarianten der wenigstens zwei sich konstruktiv unterscheidenden Typen von Steuergerätemodulen ausgelegt ist. Unter einer Ausstattungsvariante wird hierbei verstanden, dass eine ansonsten in ihren geometrischen Abmessungen unveränderte Leiterplatte unterschiedlich bestückt, d. h., mit unterschiedlichen elektronischen Bauelementen versehen ist. So können sich insbesondere bei einem Steuergerätemodul für die Steuerung eines Kraftfahrzeug-Fensterhebers die einzelnen Ausstattungsvarianten - insbesondere in Abhängigkeit davon, ob der zu steuernde Fensterheber auf der Fahrerseite oder der Beifahrerseite oder im Frontbereich des Fahrzeuginnenraumes oder im Font angeordnet ist - funktionell voneinander unterscheiden. Beispielsweise kann in einer Ausstattungsvariante über das Steuergerätemodul eines ersten oder zweiten Typs ein Einklemmschutz, in einer weiteren Ausstattungsvariante nur ein manueller Lauf oder in einer dritten Ausführungsvariante nur ein Automatiklauf beim Öffnen der Fensterscheibe bereitgestellt sein. Das Gehäuse ist hierbei so dimensioniert, dass alle möglichen Bestückungen und damit Ausstattungsvarianten der Steuergerätemodule des ersten oder des zweiten Typs in dem Gehäuse aufgenommen werden können.

In einem bevorzugten Ausführungsbeispiel ist ferner eine an dem Gehäuse ausgebildete Gehäuseöffnung für einen Steckverbinder durch ein Verschlusselement verschließbar. Das Verschlusselement dient hierbei dem vorzugsweise dichtenden Verschließen derjenigen Gehäuseöffnung, in der bei dem verwendeten Steuergerätemodul kein Steckverbinder gehalten werden muss. Das Verschlusselement dient somit dem Verschließen einer jeweils ungenutzten, freibleibenden Gehäuseöffnung, um insbesondere zu verhindern, dass über diese freibleibende Gehäuseöffnung Verschmutzungen oder Feuchtigkeit in das Innere des Gehäuses gelangen können. Bei einer Montage einer Steuerungsvorrichtung kann somit durch das bereitgestellte Verschlusselement diejenige Gehäuseöffnung verschlossen werden, die aufgrund des Steuergerätemoduls, das aus den zwei zur Verfügung gestellten unterschiedlichen Typen von Steuergerätemodulen ausgewählt wurde, frei bleibt.

Das Verschlusselement wird vorzugsweise als separates, manuell an das Gehäuse (insbesondere an ein Gehäuseteil bei einem mehrteiligen Gehäuse) einsetzbares Bauteil ausgebildet. Auf diese Weise kann bei einem Zusammenbau einer Steuerungsvorrichtung aus einem zur Verfügung gestellten Bausatz von Einzelkomponenten durch den Monteur jeweils entschieden werden, welche Gehäuseöffnung aufgrund des verwendeten Typs von Steuergerätemodul zu verschließen ist, und hierfür in einfacher Weise das Verschlusselement genutzt werden. Hierbei ist vorzugsweise vorgesehen, dass an dem Gehäuse je eine Halterung ausgebildet ist, in der das Verschlusselement formschlüssig aufgenommen werden kann, um die jeweilige Gehäuseöffnung zu verschließen.

Um das Verschlusselement ferner nicht separat von einem Gehäuse anliefern zu müssen, ist in einem bevorzugten Ausführungsbeispiel weiterhin vorgesehen, das Verschlusselement verliersicher an einem Teil des Gehäuses zu befestigen und von diesem Teil vollständig entfernbar auszugestalten. Derart kann das Verschlusselement zum Verschließen der jeweiligen Gehäuseöffnung beim Zusammenbau der Steuerungsvorrichtung schnell und unkompliziert von dem Gehäuse entfernt und zum Verschließen der Gehäuseöffnung verwendet, beispielsweise in eine dafür vorgesehene Halterung des Gehäuses eingesetzt werden.

In einer Variante ist das Verschlusselement in einem Anlieferungszustand zunächst an einem Teil des Gehäuses angeformt, wobei aber die Verbindung zwischen Verschlusselement und diesem Teil des Gehäuses so ausgebildet ist, dass das Verschlusselement manuell von dem Teil des Gehäuses vollständig entfernbar ist. So kann beispielsweise in einem Verbindungsbereich zwischen dem Teil des Gehäuses und dem Verschlusselement wenigstens eine Sollbruchstelle eingebracht sein, um das Entfernen des Verschlusselements zu erleichtern.

Der Innenraum eines Gehäuses ist des Weiteren in einer Ausführungsvariante so dimensioniert, dass bei der zumindest teilweisen Aufnahme der Leiterplatte eines Steuergerätemoduls des ersten Typs in einem Bereich innerhalb des Gehäuses ein ungenutzter Freiraum verbleibt und bei der zumindest teilweisen Aufnahme der Leiterplatte eines Steuergerätemoduls des zweiten Typs in demselben Bereich wenigstens einen Abschnitt der Leiterplattes des Steuergerätemoduls des zweiten Typs angeordnet wird. Der Innenraum des Gehäuses, in dem jeweils eine Leiterplatte eines Steuergerätemoduls zumindest teilweise aufzunehmen und bestimmungsgemäß zu lagern ist, ist hier folglich zumindest für eine Leiterplatte eines Typs von Steuergerätemodul überdimensioniert, so dass ein ungenutzter Freiraum innerhalb des Gehäuses verbleibt. Bei der Anordnung der Leiterplatte eines anderen Typs von Steuergerätemodul wird demgegenüber derselbe Bereich von der unterschiedlich ausgestalteten Leiterplatte genutzt, wenn diese bestimmungsgemäß in dem Gehäuse gelagert ist.

Hierbei kann in einer Weiterbildung vorgesehen sein, dass das Gehäuse so dimensioniert ist, dass bei allen Typen von Steuergerätemodulen immer ein ungenutzter Freiraum verbleibt. Das Gehäuse ist somit eigentlich für die einzelnen Leiterplatten der einzusetzenden Typen von Steuergerätemodulen jeweils überdimensioniert. Das Gehäuse gestattet hierdurch insbesondere die Aufnahme von konstruktiv unterschiedlich ausgestalteten Leiterplatten, die sich hinsichtlich ihrer geometrischen Form, ihren Abmessungen und/oder ihrer jeweiligen Ausrichtung zu einem bei allen Typen von Steuergerätemodulen vorgesehenen Komponente, die stets an derselben Stelle des Gehäuses zu befestigten ist, unterscheiden.

In einem Ausführungsbeispiel weisen die unterschiedlichen Typen von Steuergerätemodulen z. B. jeweils einen Steckverbinder zum Anschluss des Steuergerätemoduls an ein übergeordnetes Steuerungssystem auf, der stets an einer übereinstimmenden Stelle an dem Gehäuse zu befestigen ist. Die einzelnen Steuergerätemodule weisen folglich hier jeweils einen übereinstimmenden Steckverbinder auf, der gegebenenfalls zusätzlich zu einem in einer Gehäuseöffnung gehaltenen (Motor-)Steckverbinder vorgesehen und mit der Leiterplatte verbunden ist. In Abhängigkeit von dem Typ des verwendeten Steuergerätemoduls (z.B. für eine rechte oder für eine linke Fahrzeugseite) wird dieser Motorsteckverbinder üblicherweise an einer anderen Stelle angeordnet sein. Bei den beiden Typen von Steuergerätemodulen ist zwar der Steckverbinder zum Anschluss an ein übergeordnetes Steuerungssystem an dem Gehäuse stets identisch platziert ist, der Motorsteckverbinder zum Anschluss an die zu steuernde Antriebseinheit aber muss jeweils an einer andere Stelle an dem Gehäuse herausgeführt sein.

Vorzugsweise stellt das Gehäuse auch für einen Fall einen ausreichend großen Innenraum zur Verfügung, bei dem die wenigstens zwei wahlweise unterzubringenden Leiterplatten im unbestückten Zustand jeweils nicht symmetrisch, insbesondere nicht punkt- oder achssymmetrisch ausgebildet sind.

In einer Ausführungsvariante weist das Gehäuse wenigstens zwei miteinander verbundene Gehäuseteile auf, die in verbundenem Zustand den Innenraum des Gehäuses definieren, in dem die Leiterplatte des jeweiligen Steuergerätemoduls wenigstens teilweise aufgenommen ist. Beispielsweise ist das Gehäuse hier aus zwei Gehäusehälften zusammengesetzt. Diese Gehäusehälften sind vorzugsweise manuell miteinander verbindbar, insbesondere über wenigstens eine Rastverbindung, um das Gehäuse möglichst einfach und schnell aus den beiden Gehäuseteilen zusammensetzen zu können.

Weiterhin ist das Gehäuse (ohne ein daran befestigtes oder gehaltenes Verschlusselement) bevorzugt symmetrisch, insbesondere spiegelsymmetrisch zu einer Symmetrieachse ausgebildet. Dies ist insbesondere bei einem Gehäuse vorteilhaft, das sowohl für ein Steuergerätemodul eines ersten Typs, das auf einer ersten (z. B. linken) Fahrzeugseite einzusetzen ist, als auch für ein Steuergerätemodul eines zweiten Typs, das auf der anderen (rechten) Fahrzeugseite einzusetzen ist, gedacht ist. Hier sind dann insbesondere etwaige Gehäuseöffnungen und an dem Gehäuse vorgesehene Haltemittel, über die das Gehäuse an einer zu steuernden Antriebseinheit fixierbar ist, zu einer Symmetrieachse spiegelsymmetrisch angeordnet, so dass das Gehäuse für beide Fahrzeugseiten mit dem jeweiligen darin aufgenommenen Steuergerätemodul ohne Weiteres verwendbar ist.

Ein weiterer wesentlicher Vorteil der vorliegenden Erfindung ist die Möglichkeit, einen Bausatz für eine Steuerungsvorrichtung bereitzustellen, bei dem mit einem einzigen Gehäuse unterschiedliche Steuerungsvorrichtungen montiert werden können. Dabei werden ein Gehäuse der vorgenannten Art und ein Satz von wenigstens zwei Steuergerätemodulen unterschiedlicher Typen bereitgestellt, die jeweils zum Anschluss an eine zu steuernde Antriebseinheit eingerichtet und vorgesehen sind. Indem das Gehäuse für beide Typen von Steuergerätemodulen geeignet ist, kann diese mit wahlweise mit dem einen oder anderen Typ von Steuermodul kombiniert werden, um eine Steuerungsvorrichtung zu montieren.

Hierbei kann es beispielsweise bei einer Antriebseinheit einer Kraftfahrzeugverstelleinrichtung von deren vorgesehenem Anbringungsort innerhalb eines Kraftfahrzeugs abhängen, welches Steuergerätemodul bei der Montage auszuwählen und in dem bereitgestellten Gehäuse anzuordnen ist. So können bei einem solchen Bausatz ein Gehäuse und zwei elektronischen Steuergerätemodulen bereitgestellt sein, die jeweils mit einer von zwei zueinander unterschiedlichen Leiterplatten ausgestattet sind und jeweils zumindest teilweise an dem Gehäuse untergebracht und gelagert werden können. In Abhängigkeit davon, ob die zu montierende Steuerungsvorrichtung für eine Antriebseinheit für einen Fensterheber in einer linken oder einer rechten Kraftfahrzeugtür vorgesehen ist, wird das eine oder das andere Steuergerätemodul ausgewählt und mit dem Gehäuse kombiniert.

Vorzugsweise sind die wenigstens zwei unterschiedlichen Typen von Steuergerätemodulen mit Leiterplatten ausgestattet, die im Wesentlichen dieselben geometrischen Abmessungen aufweisen. Die unbestückte Leiterplatte eines Steuergerätemoduls eines ersten Typs weist somit insbesondere im Wesentlichen dieselben Abmaße auf wie eine unbestückte Leiterplatte eines Steuergerätemoduls eines zweiten Typs.

In einer bevorzugten Ausführungsvariante eines Bausatzes sind die Leiterplatten der bereitgestellten Steuergerätemodule im unbestückten Zustand zueinander symmetrisch ausgebildet. Eine bevorzugte Ausführungsvariante kann sich hierbei insbesondere dadurch auszeichnen, dass zwei unterschiedliche Leiterplatten, von denen die eine für ein Steuergerätemodul des ersten Typs und die andere Leiterplatte für ein Steuergerätemodul des zweiten Typs ausgebildet ist, im unbestückten Zustand zueinander spiegelsymmetrisch ausgebildet sind. Eine Grundfläche der beiden Leiterplatten kann hierbei durchaus selbst nicht punkt- oder achssymmetrisch sein. Aufgrund der Achssymmetrie der beiden unbestückten Leiterplatten zueinander weisen diese aber dieselben geometrischen Abmessungen auf. Für beide Typen von Steuergerätemodulen ist somit nur eine bestimmte Leiterplatten-Grundform verwendet, auf die das Gehäuse in einfacher Weise anpassbar ist, um die beiden Typen von Steuergerätemodulen schützend aufzunehmen.

Ein weiterer Aspekt der vorliegenden Erfindung ist die Bereitstellung eines Verfahrens zur Montage einer Steuerungsvorrichtung, insbesondere aus einem vorgenannten Bausatz, bei dem aus den wenigen voneinander unterschiedlichen Komponenten, wie den wenigstens zwei unterschiedlichen Leiterplatten und ansonsten identischen Komponenten, wie einem bestimmten Gehäuse, unterschiedliche Typen von Steuerungsvorrichtungen montiert werden können. Dabei sind diese unterschiedlichen Typen von Steuerungsvorrichtungen vorzugsweise jeweils zur Steuerung einer Antriebseinheit einer Kraftfahrzeugverstelleinrichtung, wie z. B. einem Fensterheber, vorgesehen und unterscheiden sich konstruktiv dadurch, dass die eine Steuerungsvorrichtung für die Anordnung in einer linken Kraftfahrzeugtür und die andere Steuerungsvorrichtung für die Anordnung in einer rechten Kraftfahrzeugtür vorgesehen ist.

Ein solcher Bausatz kann zudem so erweitert sein, dass damit auch Steuerungsvorrichtungen zur Unterbringung in einem Nassraum einer (linken oder rechten) Kraftfahrzeugtür montierbar sind. Hierbei hat es sich insbesondere als vorteilhaft herausgestellt, identische Leiterplatten zur Herstellung eines Steuergerätemoduls für eine bestimmte Seite des Kraftfahrzeugs zu verwenden, unabhängig davon, ob die damit zu montierende Steuerungsvorrichtung für einen Nass- oder Trockenraum zu verwenden ist.

Bei einem anderen, nicht erfindungsgemäßen Verfahren wird eine vorgefertigte Steckverbindereinheit, die wenigstens einen Steckverbinder - vorzugsweise zum Anschluss eines Steuergerätemoduls an ein Kabel eines übergeordneten Steuerungssystems - und einen Schnittstellenbereich zur elektrischen Verbindung des Steckverbinders mit einer Leiterplatte aufweist, dazu benutzt, hiermit Steuergerätemodule herzustellen, die entweder für die Kombination mit einem Gehäuse einer ersten Art oder für die Kombination mit einem Gehäuse einer zweiten Art geeignet sind. Die einzelnen Gehäusearten sind dabei konstruktiv derart verschieden zueinander, dass ein Steuergerätemodul, das für ein Gehäuse einer ersten Art ausgebildet und vorgesehen ist, nicht bestimmungsgemäß in einem Gehäuse einer zweiten Art aufgenommen werden kann.

Im Zuge eines solchen Verfahrens sind nun die folgenden Schritte vorgesehen:
- Bereitstellen einer Leiterplatte,
- Bereitstellen einer vorgefertigten Steckverbindereinheit mit einem Steckverbinder und einem Schnittstellenbereich zur elektrischen Verbindung des Steckverbinders mit der Leiterplatte,
- Verbinden der Leiterplatte mit der Steckverbindereinheit zur Herstellung des Steuergerätemoduls,
und wahlweise
- Befestigen des Steuergerätemoduls über wenigstens einen ersten Befestigungsbereich der vorgefertigten Steckverbindereinheit an einem Gehäuse einer ersten Art, das im zusammengebauten Zustand der Steuerungsvorrichtung wenigstens die Leiterplatte zumindest teilweise aufnimmt,
   oder
- Anformen einer Befestigungsstruktur mit wenigstens einem von dem ersten Befestigungsbereich verschiedenen, zweiten Befestigungsbereich an die vorgefertigte Steckverbindereinheit und Befestigen des Steuergerätemoduls über diesen wenigstens einen zweiten Befestigungsbereich an einem Gehäuse einer zweiten Art, das im zusammengebauten Zustand der Steuerungsvorrichtung wenigstens die Leiterplatte zumindest teilweise aufnimmt.

Bei diesem Verfahren wird folglich eine vorgefertigte Steckverbindereinheit, die bereits einen Befestigungsbereich zur bestimmungsgemäßen Befestigung der Steckverbindereinheit an einem Gehäuse einer ersten Art aufweist, dazu verwendet, als vorgefertigte Baueinheit bzw. Grundform zu dienen, an der eine Befestigungsstruktur angeformt wird, die für eine bestimmungsgemäße Befestigung an einem Gehäuse einer zweiten Art ausgebildet und vorgesehen ist.

Die Steckverbindereinheit wird hier vorzugsweise als Vorspritzling benutzt, an den in einem Spritzgussverfahren die Befestigungsstruktur angespritzt wird.

Die Verbindung der Leiterplatte mit der Steckverbindereinheit kann nach der Anformung der Befestigungsstruktur erfolgen. Hierbei kann auch vorgesehen sein, dass die Befestigungsstruktur selbst mit der Leiterplatte direkt verbunden wird, um das jeweilige Steuergerätemodul fertig zu stellen. Die Leiterplatte wird hierbei bevorzugt an einem Abschnitt der Befestigungsstruktur und dem Schnittstellenbereich der Steckverbindereinheit befestigt.

Alternativ oder ergänzend kann an der Befestigungsstruktur auch ein weiterer (Motor-) Steckverbinder vorgesehen sein, der zum Anschluss des Steuergerätemoduls an die zu steuernde Antriebseinheit vorgesehen ist und von dem Steckverbinder der Steckverbindereinheit verschieden ist.

Weiterhin kann die Befestigungsstruktur in einer Ausführungsvariante eine Abdeckung aufweisen, mittels der das Gehäuse der zweiten Art - vorzugsweise dichtend - verschlossen wird, wenn das Steuergerätemodul an dem Gehäuse befestigt wird. Die angeformte Befestigungsstruktur bildet somit vorzugsweise ein Deckelelement für das Gehäuse der zweiten Art aus. Dabei wird über dieses Deckelelement eine Einführöffnung verschlossen, über die ein Steuergerätemodul, das wenigstens durch die Steckverbindereinheit, die daran angeformte Befestigungsstruktur und die zumindest mit der Steckverbindereinheit verbundene Leiterplatte gebildet ist, in das Gehäuse einzuführen ist.

Für ein dichtendes Verschließen des Gehäuses über die Abdeckung der Befestigungsstruktur wird an der Befestigungsstruktur bevorzugt ein Dichtelement vorgesehen. Dieses Dichtelement ist in einem Ausführungsbeispiel ebenfalls angeformt und aus einer Weichkomponente hergestellt.

In einer Ausführungsvariante ist das Gehäuse der ersten Art für die Anordnung in einem Trockenraum innerhalb eines Kraftfahrzeugs und das hierzu konstruktiv verschiedenartig ausgebildete Gehäuse der zweiten Art für die Anordnung in einem Nassraum innerhalb eines Kraftfahrzeugs ausgebildet und vorgesehen. Hierbei wird unter einem Trockenraum ein Bereich, z. B. innerhalb einer Kraftfahrzeugtür, verstanden, der weitestgehend nach außen abgedichtet ist, so dass insbesondere keine Feuchtigkeit von außerhalb des Kraftfahrzeugs in diesen Bereich eindringen kann. Unter einem Nassraum wird demgegenüber üblicherweise ein Bereich, z. B. innerhalb einer Kraftfahrzeugtür zwischen einer Türaußenhaut und einem Aggregateträger, verstanden, in den von außerhalb des Kraftfahrzeugs Feuchtigkeit in nennenswertem Umfang gelangen kann, so dass hierin angeordnete, elektronische Komponenten in einem sie schützenden und vorzugsweise selbst abgedichteten Gehäuse unterzubringen sind.

Über das beschriebene, aber nicht-erfindungsgemäße Verfahren wird somit gleichfalls die gestellte Aufgabe gelöst, da hierdurch ebenfalls unterschiedlich geartete Steuerungsvorrichtungen in einfacher und kostengünstiger Weise mittels eines nur wenige unterschiedliche Komponenten aufweisenden Bausatzes hergestellt werden können. So kann insbesondere vorgesehen sein, dass übereinstimmende Leiterplatten für einen Nassraum und für einen Trockenraum vorgesehen sind, sofern sich diese auf derselben Fahrzeuglängsseite befinden. Die Leiterplatten werden stets mit derselben Steckverbindereinheit verbunden und es wird lediglich in Abhängigkeit davon, ob das herzustellende Steuergerätemodul in einem Nassraum oder in einem Trockenraum Verwendung finden soll, eine Befestigungsstruktur an dieser Steckverbindereinheit angeformt oder nicht.

Weitere Merkmale und Vorteile der vorliegenden Erfindung werden durch die nachfolgende Beschreibung von Ausführungsbeispielen anhand der Figuren deutlich werden.

Es zeigen:
- Fig. 1A - 1C: verschiedene perspektivische Ansichten eines Ausführungsbeispiels einer Steuerungsvorrichtung in Form eines Steuergeräts mit einem erfindungsgemäßen Gehäuses, das an einer Antriebseinheit einsteckbar ist;
- Fig. 2A - 2C: unterschiedliche perspektivische Ansichten eines vorgefertigten Steuergerätemoduls eines ersten Typs, das in dem Gehäuse der Figuren 1A - 1C größtenteils aufgenommen ist;
- Fig. 3A - 3B: perspektivische Ansichten eines Steuergeräts mit einem Gehäuse, das mit dem Gehäuse des Steuergeräts der Figuren 1A - 1C übereinstimmt, in dem jedoch ein sich konstruktiv unterscheidendes Steuergerätemodul eines zweiten Typs aufgenommen ist;
- Fig. 4A - 4C: das Steuergerätemodul für das Steuergerät der Figuren 3A und 3B in unterschiedlichen perspektivischen Ansichten;
- Fig. 5A - 5B: perspektivische Ansichten einer Steckverbindereinheit, die sowohl bei dem Steuergerätemodul des ersten Typs als auch bei dem Steuergerätemodul des zweiten Typs eingesetzt ist;
- Fig. 6: eine perspektivische Ansicht eines ersten Gehäuseteils des zweiteilig aufgebauten Gehäuses der vorangegangenen Figuren;
- Fig. 7: eine perspektivische Ansicht eines zweiten Gehäuseteils;
- Fig. 8A - 8C: Detaildarstellungen des ersten Gehäuseteils und des zusammengebauten Gehäuses zur Veranschaulichung eines Verschließens einer Gehäuseöffnung an dem Gehäuse durch ein an dem ersten Gehäuseteil angeformtes und vollständig von diesem entfernbares Verschlusselement;
- Fig. 9A - 9B: zwei perspektivische Ansichten des Gehäuses mit jeweils einer durch das Verschlusselement verschlossenen Gehäuseöffnung;
- Fig. 10: eine erste Antriebseinheit mit daran fixiertem Steuergerät, das ein Steuergerätemodul des ersten Typs aufweist;
- Fig. 11: eine zweite Antriebseinheit mit daran fixiertem Steuergerät, das ein Steuergerätemodul des zweiten Typs aufweist;
- Fig. 12A - 12B: perspektivische Ansichten eines weiteren Steuergerätemoduls, das in ein Gehäuse einer zweiten Art, das sich konstruktiv von dem Gehäuse der vorangegangenen Figuren unterscheidet, einsetzbar ist;
- Fig. 12C - 12D: perspektivische Detaildarstellungen des Steuergerätemoduls der Figuren 12A und 12B ohne Leiterplatte zur Veranschaulichung der Herstellung dieses Steuergerätemoduls mit einer Steckverbindereinheit gemäß den Figuren 5A und 5B;
- Fig. 13A - 13B: eine weitere Antriebseinheit mit einem Gehäuse der zweiten Art, in das das Steuergerätemodul gemäß den Figuren 12A bis 12D eingesetzt ist.

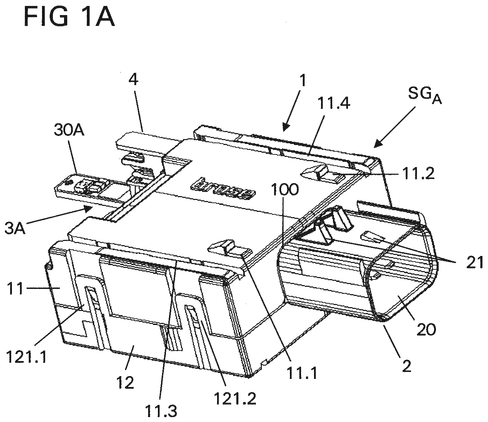

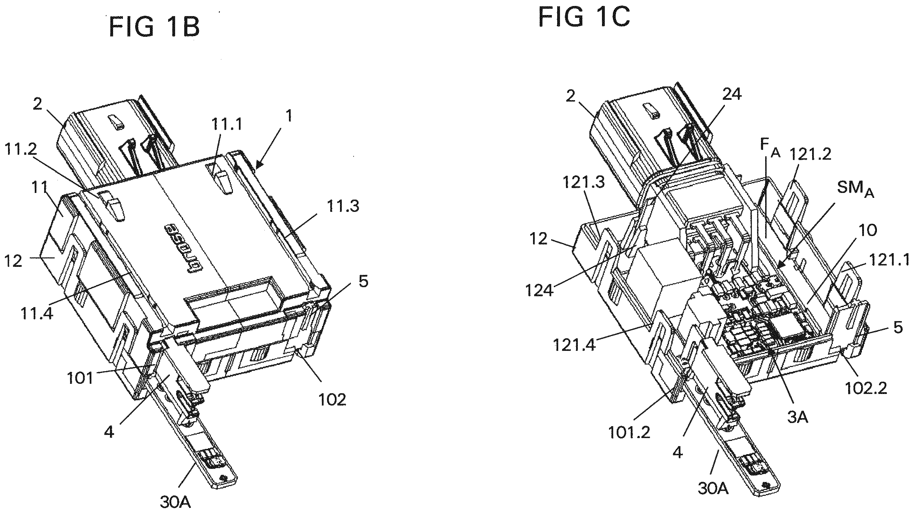

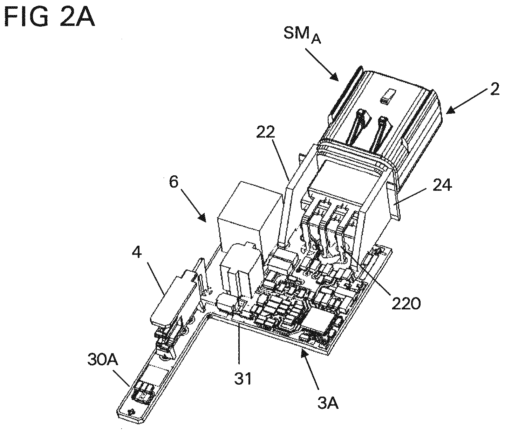

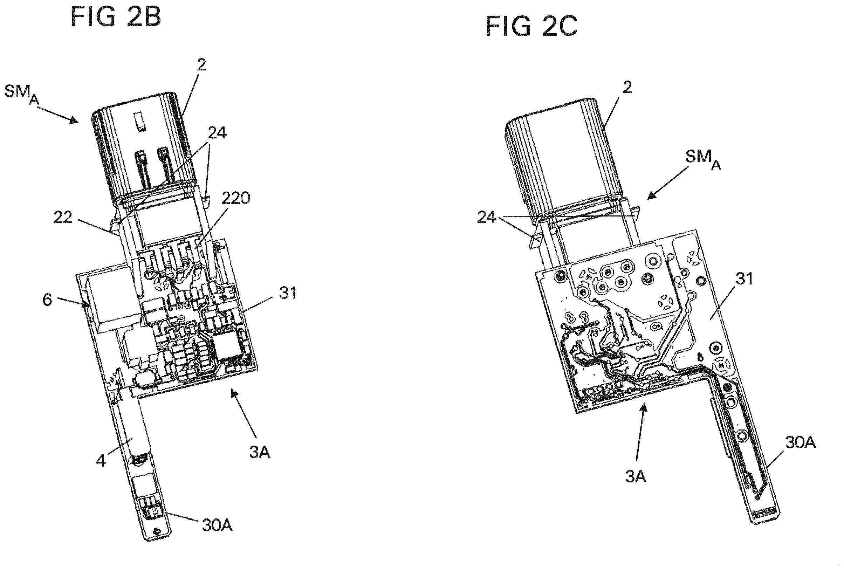

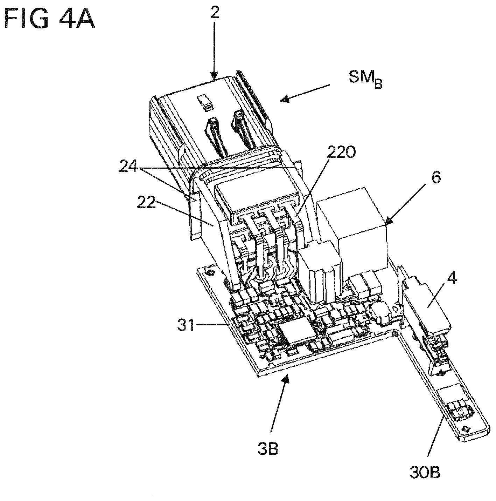

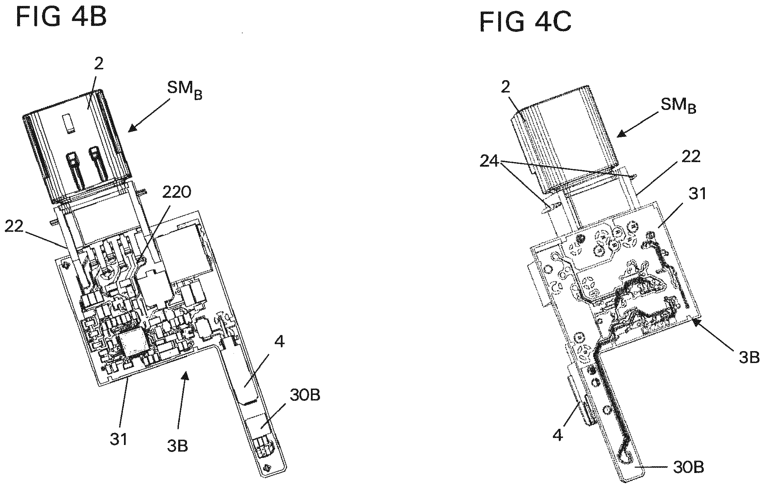

Die Figuren 1A und 1B zeigen in perspektivischer Ansicht eine zusammengebaute Steuerungsvorrichtung in Form eines Steuergeräts SG_{A}, das hier zur elektronischen Steuerung einer motorischen Antriebseinheit für einen Kraftfahrzeug-Fensterheber eingerichtet und vorgesehen ist. Das Steuergerät SG_{A} weist hierbei ein Ausführungsbeispiel eines erfindungsgemäßen Gehäuses 1 auf, in dem wesentliche elektronische Komponenten des Steuergeräts SG_{A} aufgenommen sind. So dient das Gehäuse 1 hier der Lagerung eines Steuergerätemoduls SM_{A}, das in den Figuren 2A bis 2C in Einzelansichten gezeigt ist, oder eines Steuergerätemoduls SM_{B}, das in den Figuren 4A bis 4C gezeigt ist, und nimmt in seinem Inneren insbesondere wesentliche Teile einer bestückten Leiterplatte 3A, 3B des jeweiligen Steuergerätemoduls SM_{A}, SM_{B} schützend auf.

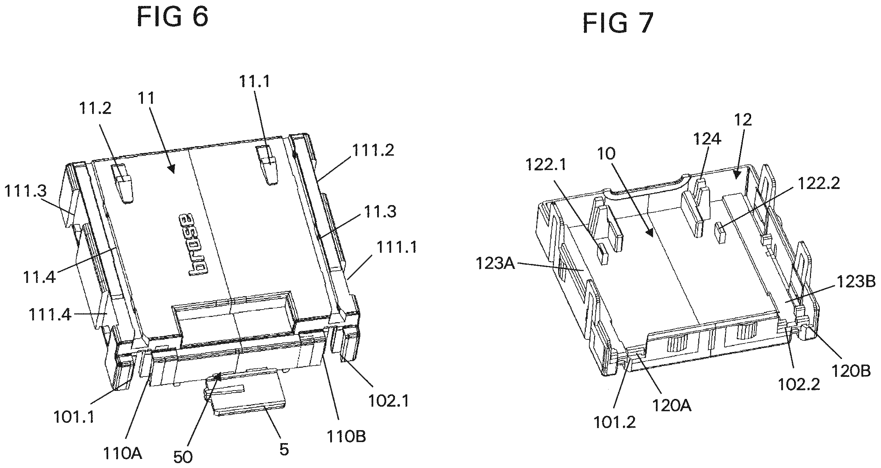

Das Gehäuse 1 ist hier aus zwei Gehäuseteilen 11, 12 gebildet. Diese beiden Gehäuseteile 11, 12 bilden jeweils eine Hälfte des Gehäuses 1 und definieren eine Ober- und Unterschale des Gehäuses 1. Die beiden Gehäuseteile 11, 12 sind über eine Rastverbindung aneinander fixiert. Diese Rastverbindung wird hier durch vier laschenartige Rasthaken in Verbindungsbereichen 121.1 bis 121.4 an dem einen, zweiten Gehäuseteil 12 sowie durch Rastnasen an dem anderen, ersten Gehäuseteil 11 gebildet. In die diese Rastnasen in Verbindungsbereichen 111.1 bis 111.4 (vgl. Figur 6) rasten die elastisch vorgespannten Rasthaken des zweiten Gehäuseteils 12 ein, wenn die beiden Gehäuseteile 11, 12 bestimmungsgemäß aneinandergedrückt werden.

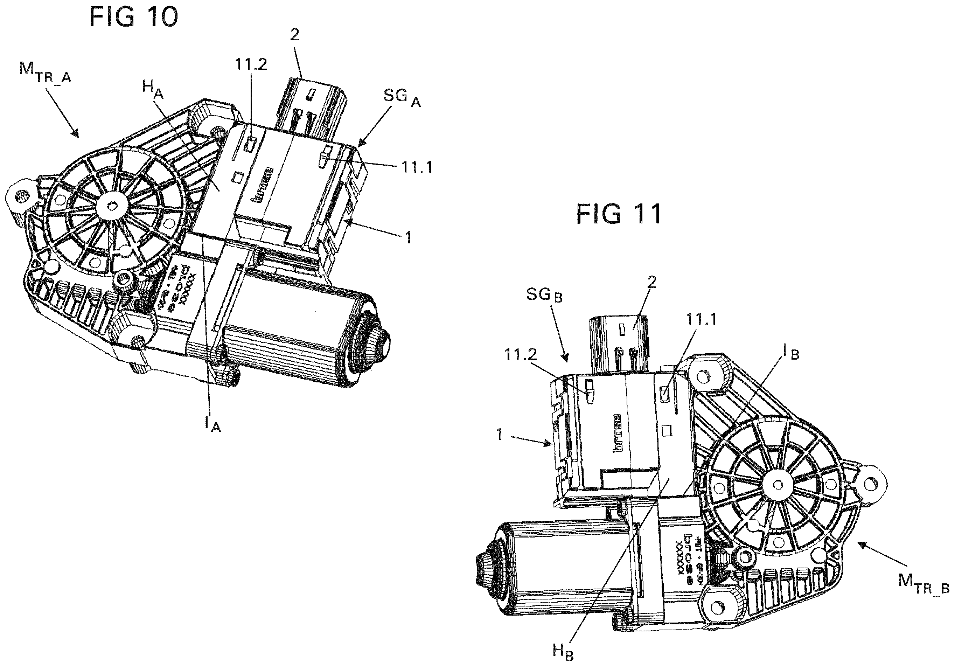

An einer Außenseite des ersten Gehäuseteils 11 sind ferner Haltemittel 11.1 und 11.2 ausgeformt, die der Anbindung des Gehäuses 1 an eine motorische Antriebseinheit M_{TR_A} oder M_{TR_B} dienen, wie sie in den Figuren 10 und 11 dargestellt sind. Über je eines der beiden Haltemittel 11.1 und 11.2 ist das Gehäuse 1 wahlweise an einer Halterung H_{A} der einen Antriebseinheit M_{TR_A} oder an einer Halterung H_{B} der anderen Antriebseinheit M_{TR_B} fixierbar. Die beiden Haltemittel 11.1 und 11.2 sind hierfür als Rastnasen ausgebildet, die in eine korrespondierende Rastöffnung an der jeweiligen Halterung H_{A}, H_{B} formschlüssig eingreifen können, um das Gehäuse 1 an der jeweiligen Antriebseinheit M_{TR_A}, M_{TR_B} festzulegen.

Eine Halterung H_{A}, H_{B} ist herbei jeweils durch einen im Querschnitt U-förmigen, schienenartigen Abschnitt an dem Gehäuse der jeweiligen motorischen Antriebseinheit M_{TR_A}, M_{TR_B} ausgebildet. Um das zusammengebaute Gehäuse 1 leichter in die jeweilige Halterung H_{A}, H_{B} einführen zu können, weist das Gehäuse zwei sich parallel gegenüberliegende Gleitführungen 11.3, 11.4 auf. Eine Gleitführung 11.3, 11.4 ist hier jeweils einem der beiden Haltemittel 11.1, 11.3 zugeordnet. In eine Gleitführung 11.3, 11.4 kann ein vorspringender Zapfen (oder Steg) der Halterung H_{A}, H_{B} eingreifen, so dass das Gehäuse 1 an diesem vorspringenden Zapfen (oder Steg) entlang geführt ist, bis das Gehäuse 1 eine bestimmungsgemäße Endlage erreicht, in der das jeweilige Haltemittel 11.1, 11.2 mit der Halterung H_{A} bzw. H_{B} verrastet.

Das Gehäuse 1 ist hier spiegelsymmetrisch zu einer Längsachse ausgebildet. Es ist dazu ausgebildet und vorgesehen, die wahlweise eines der zwei voneinander unterschiedlichen Steuergerätemodule SM_{A}, SM_{B} zu halten und insbesondere zumindest teilweise jeweils deren bestückte Leiterplatte 3A, 3B in seinem Inneren aufzunehmen. Für beide Typen von Steuergerätemodulen SM_{A}, SM_{B} weist das Gehäuse 1 eine Aussparung 100 auf, in der ein Steckverbinder einer Steckverbindereinheit 2 formschlüssig gehalten ist, so dass an diesen Steckverbinder von außerhalb des Gehäuses 1 ein Anschlusskabel angeschlossen werden kann. Die Steckverbindereinheit 2 definiert hier einen Einbaustecker, an den ein übergeordnetes Steuerungssystem angeschlossen werden kann. Zur Fixierung eines Anschlusssteckers an dem Steckergehäuse 20 weist dieser zusätzliche Haltemittel 21 auf. Diese gleichermaßen als vorspringende Rastnasen ausgebildeten Haltemittel 21 verrasten mit dem korrespondierenden Anschlussstecker, wenn dieser bestimmungsgemäß mit dem Steckverbinder der Steckverbindereinheit 2 verbunden ist, um ein unbeabsichtigtes Trennen der Steckverbindung zu verhindern.

An einer der Steckverbindereinheit 2 diametral gegenüberliegenden Seite des Gehäuses 1 weist das Gehäuse 1 zwei symmetrisch zueinander ausgebildete Gehäuseöffnungen 101, 102 auf. Diese sind jeweils für die Halterung eines Motorsteckverbinders 4 vorgesehen, der Teil des jeweiligen Steuergerätemoduls SM_{A}, SM_{B} entsprechend den Figuren 2A bis 2C oder 4A bis 4C ist. In einer der Gehäuseöffnungen 101, 102 wird somit der jeweilige Motorsteckverbinder 4 gehalten.

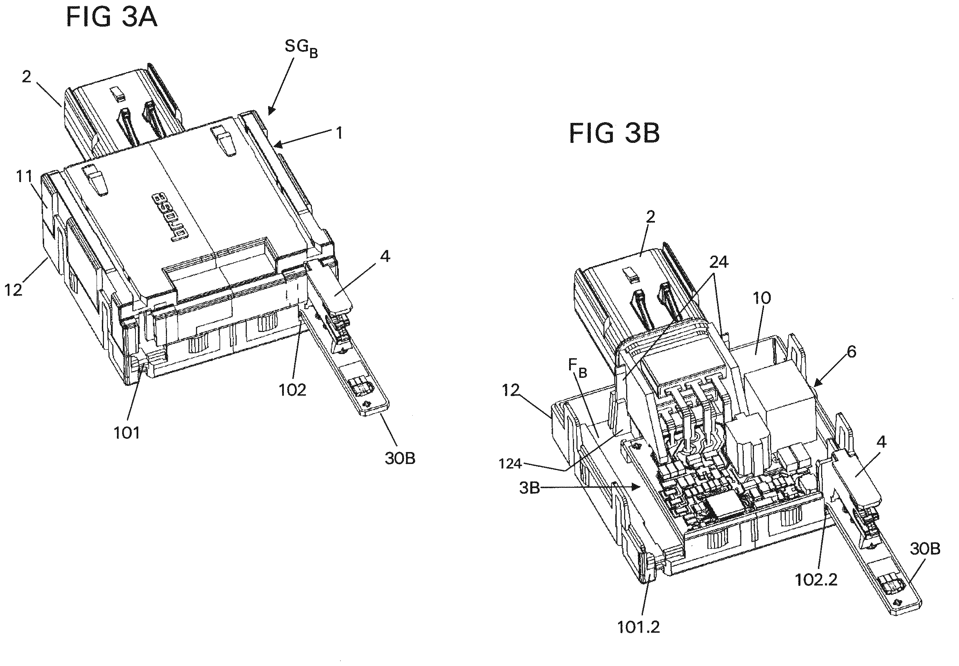

Das Halten in der jeweiligen Gehäuseöffnung 101, 102 erfolgt hierbei jeweils derart, dass der Motorsteckverbinder 4 zum Anschließen des jeweiligen zusammengebauten Steuergeräts SG_{A} (entsprechend den Figuren 1A bis 1B) oder SG_{B} (entsprechend der Figur 3A) an die jeweilige Antriebseinheit M_{TR_A}, M_{TR_B} von außerhalb des Gehäuses 1 zugänglich ist. Der an dem Gehäuse somit jeweils vorstehende Motorsteckverbinder 4 kann in einfacher Weise in einen korrespondierenden Steckverbinder, z. B. eine Buchse, an dem Gehäuse der jeweiligen Antriebseinheit M_{TR_A}, M_{TR_B} eingesteckt werden. Der Motorsteckverbinder 4 ist hier sowohl bei einem Steuergerätemodul SM_{A} des ersten Typs entsprechend den Figuren 2A bis 2C als auch bei einem Steuergerätemodul SM_{B} eines zweiten Typs entsprechend den Figuren 4A bis 4C unmittelbar auf der Bestückungsseite einer zugehörigen Leiterplatte 3A, 3B befestigt.

Der Motorsteckverbinder 4 liegt dabei jeweils an einem Leiterplattenabschnitt 30A oder 30B vor, der jeweils fingerartig von einem rechteckförmigen Basisabschnitt 31 der jeweiligen Leiterplatte 3A, 3B hervorsteht. Dieser fingerartige Leiterplattenabschnitt 30A, 30B ist im zusammengebauten Zustand des jeweiligen Steuergeräts SG_{A}, SG_{B} durch die jeweils zugeordnete Gehäuseöffnung 101 oder 102 des Gehäuses 1 herausgeführt, wenn das Steuergerätemodul SM_{A} bzw. SM_{B} bestimmungsgemäß an dem Gehäuse 1 gelagert ist. Der fingerartige Leiterabschnitt 30A, 30B trägt hier ferner wenigstens einen Hall-Sensor und ist zum Einführen in das Innere des Gehäuses der jeweiligen Antriebseinheit M_{TR_A}, M_{TR_B} vorgesehen.

Durch die Bereitstellung zweier Gehäuseöffnungen 101, 102 an dem Gehäuse 1 und eine Dimensionierung des Gehäuses 1 derart, dass es in seinem Inneren unterschiedlich ausgebildete Leiterplatten 3A, 3B schützend aufnehmen kann, ist das vorliegende Gehäuse 1 für unterschiedliche Steuergerätemodule SM_{A}, SM_{B} verwendbar, die sich aufgrund ihrer Anbringung auf unterschiedlichen Längsseiten eines Kraftfahrzeugs (links oder rechts) konstruktiv voneinander unterscheiden. So sind insbesondere elektronische Bauelemente 6, mit denen die jeweilige Leiterplatte 3A, 3B bestückt ist, bezogen auf die Steckverbindereinheit 2 jeweils unterschiedlich angeordnet und auch der jeweils vorgesehene fingerartig vorstehende Leiterplattenabschnitt 30A, 30B muss an einer anderen Stelle des Gehäuses 1 aufgenommen und aus diesem herausgeführt werden. Das Gehäuse 1 ist aber trotz dieser konstruktiven Unterschiede mit beiden Steuergerätemodulen SM_{A}, SM_{B} kombinierbar, um ein Steuergerät SG_{A} oder SG_{B} zu montieren.

Das Gehäuse 1 ist hierfür in seinem Inneren so dimensioniert, dass bei der Aufnahme der Leiterplatte 3A des Steuergerätemoduls SM_{A} des ersten Typs, das z. B. für die linke Kraftfahrzeugseite vorgesehen ist, ein ungenutzter Freiraum F_{A} innerhalb des Gehäuses 1 verbleibt. Dieser Freiraum F_{A} ist in der Darstellung A Figur 1C ersichtlich, in der das Gehäuse 1 in einem noch unverschlossenen Zustand dargestellt ist. In diesem unverschlossenen Zustand ist das Steuergerätemodul SM_{A} bereits in das zweite, untere Gehäuseteil 12 eingesetzt, das Gehäuse ist jedoch noch nicht durch das erste, obere Gehäuseteil 11 verschlossen. Der Bereich, in dem der Freiraum F_{A} bei der Aufnahme der Leiterplatte 3A des einen Steuergerätemoduls SM_{A} ungenutzt bleibt, wird bei der Aufnahme der Leiterplatte 3B des anderen Steuergerätemoduls SM_{B} entsprechend der Figur 3B vollständig von dieser belegt. Dafür bleibt hier ein Freiraum F_{B} innerhalb des Gehäuse in einem Bereich, der dem Bereich mit dem Freiraum F_{A} gegenüberliegt. Ein Innenraum 10 des Gehäuses 1, in dem eine Leiterplatte 3A, 3B eines Steuergerätemoduls SM_{A}, SM_{B} bestimmungsgemäß zumindest teilweise aufgenommen und gelagert wird, ist somit für jede der Leiterplatten 3A, 3B überdimensioniert, so dass stets ein ungenutzter Freiraum F_{A}, F_{B} in dem Innenraum 10 verbleibt. Auf diese Weise stellt das Gehäuse 1 Bereiche in seinem Inneren bereit, die nur von einem der beiden unterzubringenden Steuergerätemodule SM_{A}, SM_{B} genutzt werden können. Es weist somit in seinem Inneren Abmessungen auf, die für beide konstruktiv unterschiedlich ausgestalteten Leiterplatten 3A, 3B geeignet sind.

Die Leiterplatten 3A, 3B, die zur Bildung der beiden unterschiedlichen Steuergerätemodule SM_{A}, SM_{B} genutzt werden, sind vorliegend im unbestückten Zustand, d. h., jeweils ohne Bauelemente 6, Steckverbindereinheit 2 und Motorsteckverbinder 4, zueinander symmetrisch ausgebildet. Zwei nebeneinander angeordnete, unbestückte Leiterplatten 3A und 3B wären folglich hier spiegelsymmetrisch zu einer zwischen ihnen verlaufenden Symmetrieachse. Durch die symmetrische Ausbildung der beiden unterschiedlichen Leiterplatten 3A, 3B, die wahlweise in dem Gehäuse 1 angeordnet werden können, kann das Gehäuse 1 symmetrisch ausgebildet werden und ist dennoch vergleichsweise kompakt, obwohl es an beide Steuergerätemodule SM_{A}, SM_{B} angepasst dimensioniert ist.

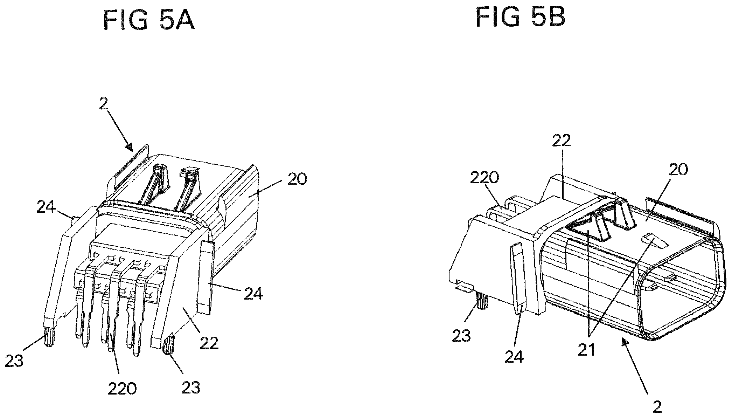

Die unterschiedlichen Typen von Steuergerätemodulen SM_{A}, SM_{B} und Steuergeräte SG_{A}, SG_{B} werden in der dargestellten Ausführungsvariante mit Hilfe eines Bausatzes hergestellt, aus dem die miteinander zu verbindenden Komponenten ausgewählt werden. Dabei werden hier lediglich unterschiedliche, insbesondere mit einem Motorsteckverbinder 4 bestückte Leiterplatten 3A, 3B für die unterschiedlichen Steuergerätemodule SM_{A}, SM_{B} vorgesehen. Bei der Herstellung wird die jeweilige Leiterplatte 3A, 3B mit einer Steckverbindereinheit 2 verbunden, die für beide Typen von Steuergerätemodulen SM_{A}, SM_{B} identisch ist. Anschließend wird das so gebildete Steuergerätemodul SM_{A}, SM_{B} in eines der Gehäuseteile 11, 12 des Gehäuses 1 des Bausatzes angeordnet. Folglich kommen für beide Steuergeräte SG_{A}, SG_{B} einige übereinstimmende Komponenten des Bausatzes zum Einsatz, wie die Steckverbindereinheit 2 und die beiden Gehäuseteile 11, 12, die in den Figuren 5A - 5B, 6 und 7 in Einzeldarstellungen gezeigt sind.

Die Steckverbindereinheit 2 gemäß der Figuren 5A - 5B weist einen an dem Steckergehäuse 20 ausgebildeten Schnittstellenbereich 22 auf, über den die Steckverbindereinheit 2 und die jeweilige Leiterplatte 3A bzw. 3B elektrisch miteinander verbunden werden können. An dem Schnittstellenbereich 22 sind hierfür mehrere Leiterpins 220 vorgesehen, die mit Leiterbahnen auf der Leiterplatte 3A oder 3B verbunden werden können. Ferner weist der Schnittstellenbereich 22 Befestigungspins 23 auf, über die die vorgefertigte Steckverbindereinheit 2 auf die Leiterplatte 3A oder 3B aufgesteckt werden kann.

An der Steckverbindereinheit 2 sind darüber hinaus zwei Befestigungsbereiche in Form von zwei schmalen Stegen 24 ausgebildet. Diese Stege 24 dienen im zusammengebauten Zustand eines Steuergerätemoduls SM_{A}, SM_{B} der Befestigung des jeweiligen Steuergerätemoduls SM_{A}, SM_{B} an einer dafür vorgesehenen Halterung 124 des Gehäuses 1. Die Halterung 124 wird hierbei durch wenigstens zwei Umgriffabschnitte bereitgestellt. Jeder dieser Umgriffabschnitte weist einen Spalt auf, in den ein zugeordneter Steg 24 der Steckverbindereinheit 2 einführbar ist, so dass der jeweilige Steg 24 darin formschlüssig gehalten ist. Beide Typen von Steuergerätemodulen SM_{A}, SM_{B} sind somit über an der vorgefertigten Steckverbindereinheit 2 vorgesehene Befestigungsbereiche 24 in dem Gehäuse 1 befestigbar. Dies ist insbesondere in den Darstellungen der Figuren 1C und 3B gut ersichtlich, in denen jeweils ein in das zweite Gehäuseteil 12 eingesetztes Steuergerätemodul SM_{A} bzw. SM_{B} gezeigt ist.

In den Figuren 5A - 5B, 6 und 7 sind im Detail die Komponenten eines zur Verfügung gestellten Bausatz dargestellt, die für alle in einem Trockenraum einsetzbaren Steuergeräte SG_{A} und SG_{B} übereinstimmen: die Steckverbindereinheit 2, das erste Gehäuseteil 11 bzw. die Oberschale des Gehäuses 1 und das zweite Gehäuseteil 12 bzw. die Unterschale des Gehäuses 1. In Verbindung mit zwei entsprechenden, unterschiedlichen Typen von Leiterplatten 3A, 3B können aus diesen Komponenten Steuergeräte SG_{A}, SG_{B} unterschiedlicher Typen hergestellt werden, die entweder zur Steuerung einer Antriebseinheit M_{TR_A}, M_{TR_B} auf der einen (z. B. linken) Fahrzeugseite oder der anderen (rechten) Fahrzeugseite eingerichtet und vorgesehen sind.

Aus der Einzelansicht des ersten Gehäuseteils 11 in der Figur 6 sind insbesondere auch die bereits erwähnten mit Rastnasen versehene Verbindungsbereiche 111.1 bis 111.4 im Detail ersichtlich, in die die laschenartigen Rasthaken des zweiten Gehäuseteils 12 eingreifen, um die beiden Gehäuseteile 11, 12 aneinander zu fixieren.

In der Figur 7 ist das zweite Gehäuseteil 12 ohne eine darin aufgenommene Leiterplatte 3A, 3B dargestellt. Hierdurch sind in den Innenraum 10 hineinragende Auflageabschnitte 122.1 und 122.2 in Form von Stegen ersichtlich sind, auf denen die jeweilige Leiterplatte 3A oder 3B bestimmungsgemäß aufliegen kann.

Innerhalb des Gehäuseteils 12 sind ferner sich gegenüberliegende randseitige Auflageabschnitte 123A und 123B vorgesehen, die hier längserstreckt und rechteckförmig erscheinen. Ein randseitiger Auflageabschnitt 123A schließt sich dabei im zusammengebauten Zustand des Gehäuses 1 an die eine (linke) Gehäuseöffnung 101 an und erstreckt sich von dieser weg in das Innere des Gehäuses 1. Der andere Auflageabschnitt 123B schließt sich demgemäß an die andere (rechte) Gehäuseöffnung 102 an und erstreckt sich von dieser weg in das Innere des Gehäuses 1. Diese randseitigen Auflageabschnitte 123A, 123B dienen jeweils nur einer der Leiterplatten 3A, 3B als Auflagefläche und verbleiben gegebenenfalls als ungenutzter Freiraum F_{A}, F_{B}. Die Auflageabschnitte 123A, 123B stellen somit jeweils nur eine Auflagefläche für eine der beiden Leiterplatten 3A, 3B für die wahlweise einzubauenden Steuergerätemodule SM_{A}, SM_{B} bereit, an der sich die Leiterplatte 3A, 3B des jeweiligen Steuergerätemoduls SM_{A}, SM_{B} abstützt.

Da durch das Einsetzen des gewünschten Steuergerätemoduls SM_{A}, SM_{B} eine der beiden zur Verfügung gestellten Gehäuseöffnungen 101, 102 ungenutzt bleibt und somit durch diese Gehäuseöffnung 101, 102 unter Umständen Verschmutzungen oder Feuchtigkeit in das Innere des Gehäuses 1 gelangen kann, ist in der dargestellten Ausführungsvariante vorgesehen, eine jeweils ungenutzte Gehäuseöffnung 101, 102 durch ein Verschlusselement 5 zu verschließen. Bei dem Verschlusselement 5 handelt es sich hier um ein plattenförmiges oder scheibenartig ausgebildetes Bauteil, das manuell in eine Halterung des Gehäuses 1 einsetzbar ist. Hierbei wird diese Halterung, in der das Verschlusselement 5 formschlüssig gehalten werden soll, durch ein Paar von Halterungsabschnitten 110A, 120A für die eine (linke) Gehäuseöffnung 101 und durch ein Paar von Halterungsabschnitten 110B, 120B für die andere (rechte) Gehäuseöffnung 102 gebildet.

Bei einem Paar von einander zugeordneten Halterungsabschnitte 110A und 120A bzw. 110B und 120B ist jeweils einer an dem ersten Gehäuseteil 11 und der andere an dem zweiten Gehäuseteil 12 ausgebildet. Die Halterungsabschnitte 110A, 110B bzw. 120A, 120B sind jeweils im Bereich einer U-förmigen Aussparung 101.1, 102.1 bzw. 101.2, 102.2 in einer Seitenwand jeweiligen Gehäuseteils 11 bzw. 12 gebildet. Zwei Aussparungen 101.1, 101.2 oder 102.1, 102.2 bilden hierbei jeweils zusammen eine der beiden Gehäuseöffnungen 101, 102 an dem zusammengebauten Gehäuse 1. Im Bereich jeder dieser Aussparungen 101.1, 101.2, 102.1, 102.2 ist eine Seitenwandung des jeweiligen Gehäuseteils 11, 12 mit Schlitzen versehen, so dass hieran das Verschlusselement 5 eingesteckt und dort gehalten werden kann.

Das Verschlusselement 5 ist in einem Anlieferungszustand an dem zweiten Gehäuseteil 11 angeordnet, vorzugsweise an diesem angeformt. Bei der Montage eines Steuergerätes SG_{A}, SG_{B} wird das Verschlusselement 5 von dem Gehäuseteil 11 vollständig entfernt und in Abhängigkeit von dem Typ des aus dem zur Verfügung gestellten Bausatz hergestellten Steuergerätemoduls SM_{A} oder SM_{B} in den einen Halterungsabschnitt 110A oder in den anderen Halterungsabschnitt 110B des Gehäuseteils 11 eingesteckt, um im zusammengebauten Zustand des Gehäuses 1 die eine Gehäuseöffnung 101 oder die andere Gehäuseöffnung 102 (dichtend) zu verschließen.

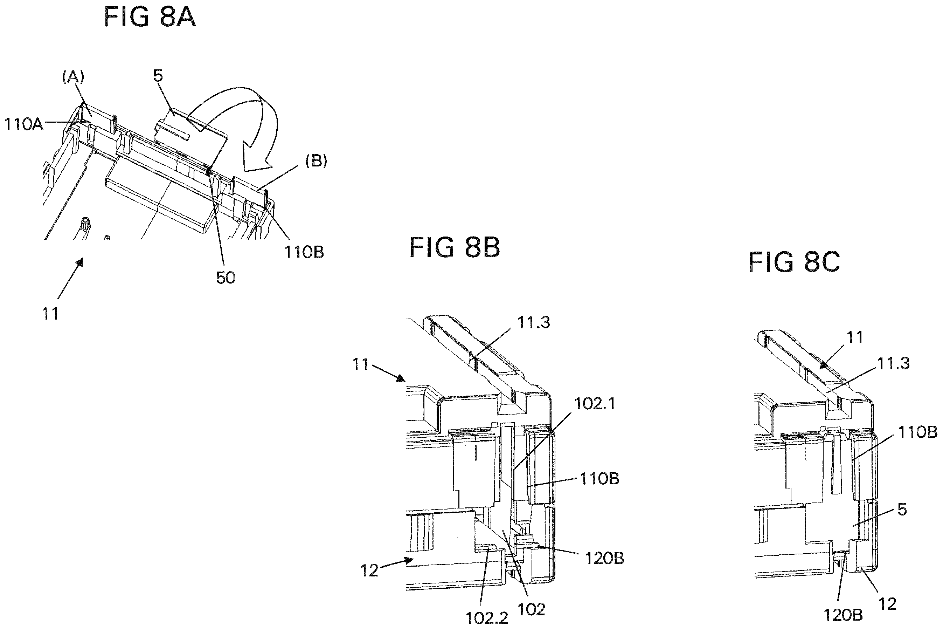

Diese Montageschritte sind in den Figuren 8A bis 8C veranschaulicht. Das Verschlusselement 5 ist zunächst über einen Verbindungsbereich mit wenigstens einer Sollbruchstelle 50 an einer Außenseite des Gehäuseteils 11 angeformt und wird durch einen Monteur manuell von dem Gehäuseteil 11 vollständig entfernt. Das von dem Gehäuseteil 11 separierte Verschlusselement 5 wird dann entweder in den einen Halterungsabschnitt 110A eingesteckt, wenn ein Steuergerätemodul SM_{B} des zweiten Typs in dem zusammenzubauenden Gehäuse 1 zu platzieren ist (Fall (A) der Figur 8A). Alternativ wird das von dem Gehäuseteil 11 separierte Verschlusselement 5 in den anderen Halterungsabschnitt 110B eingesetzt, wenn ein Steuergerätemodul SM_{A} des ersten Typs in dem zusammenzubauenden Gehäuse 1 zu platzieren ist (Fall (B) der Figur 8A). Das in dem jeweiligen Halterungsabschnitt 110A, 110B eingesetzte Verschlusselement 5 steht dabei noch - hier in etwa zur Hälfte - aus dem Halterungsabschnitt 110A bzw. 110B hervor. Der damit an dem ersten Gehäuseteil 11 überstehende Abschnitt des eingesetzten Verschlusselements 5 wird beim Verbinden der beiden Gehäuseteile 11, 12 in den jeweiligen zugeordneten Halterungsabschnitt 120A oder 120B an dem anderen, zweiten Gehäuseteil 12 eingeführt. Hierdurch ist die ungenutzte Gehäuseöffnung 101 oder 102 nach dem Verbinden der beiden Gehäuseteile 11, 12 durch das Verschlusselement 5 geschlossen.

Selbstverständlich ist es auch möglich, das Verschlusselement 5 zunächst an dem zweiten Gehäuseteil 12 einzusetzen, in dem auch vor Verbindung mit dem ersten, oberen Gehäuseteil 11 das Steuergerätemodul SM_{A} oder SM_{B} angeordnet wird, und das Verschlusselement 5 erst bei der Verbindung der beiden Gehäuseteile 11, 12 in das erste Gehäuseteil 11 eingreifen zu lassen.

In einer alternativen Ausgestaltungsvariante kann darüber hinaus vorgesehen sein, dass in die durch zwei Halterungsabschnitte 110A und 120A bzw. 110B und 120B gebildete Halterung erst nach der Verbindung der beiden Gehäuseteile 11, 12 das Verschlusselement zum Verschließen der ungenutzten Gehäuseöffnung 101 oder 102 eingesteckt wird. Die in den Figuren vorgeschlagene Ausführungsvariante wird insoweit bevorzugt, da hiermit ein Entfernen des Verschlusselements 5 nicht möglich ist, ohne auch die beiden Gehäuseteile 11, 12 voneinander zu trennen.

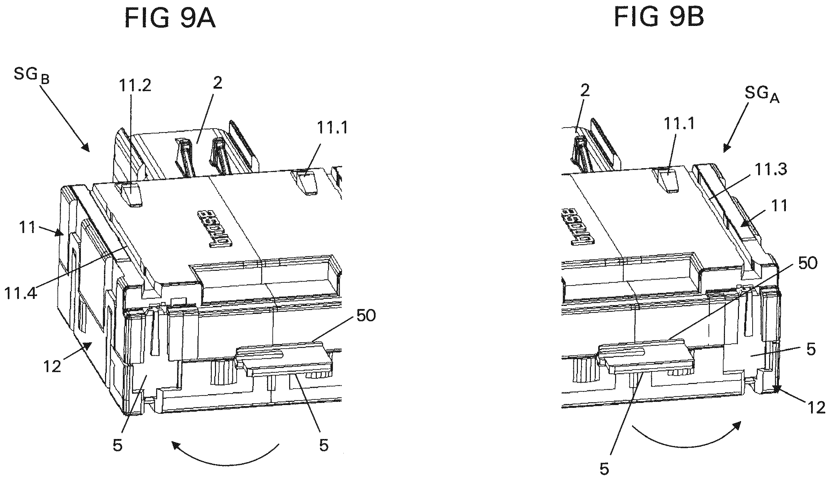

Die möglichen, unterschiedlichen Konfigurationen des Gehäuses 1 mit dem Verschlusselement 5 sind zusätzlich mit den Figuren 9A und 9B veranschaulicht. So zeigt die Figur 9A ein Steuergerät SG_{B} ausschnittsweise mit einer durch das Verschlusselement 5 verschlossenen (linken) Gehäuseöffnung 101. Die Figur 9B wiederum zeigt ein Steuergerät SG_{A} mit einer durch das Verschlusselement 5 verschlossenen (rechten) Gehäuseöffnung 102.

In den Figuren 10 und 11, auf die bereits zuvor Bezug genommen wurde, sind die beiden unterschiedlichen Antriebseinheiten M_{TR_A} und M_{TR_B} dargestellt, die jeweils zum Antrieb eines Fensterhebers auf einer Trockenraumseite einer Kraftfahrzeugtür ausgebildet sind und hierfür einen Elektromotor aufweisen, der über ein Steuergerät SG_{A} bzw. SG_{B} gesteuert werden soll. Durch die symmetrische Ausgestaltung des Gehäuses 1 kann dieses sowohl an einer Halterung H_{A} der einen Antriebseinheit M_{TR_A} als auch an einer Halterung H_{B} der anderen Antriebseinheit M_{TR_B} aufgesteckt und fixiert werden.

Lediglich in Abhängigkeit von dem in dem Gehäuse 1 platzierten Steuergerätemodul SM_{A} oder SM_{B} steht an dem Gehäuse 1 der Motorsteckverbinder 4 und der fingerartige Leiterplattenabschnitt 30A bzw. 30B aus der einen Gehäuseöffnung 101 oder aus der anderen Gehäuseöffnung 102 hervor. An einem Anschlussbereich I_{A} bzw. I_{B} der jeweiligen Antriebseinheit M_{TR_A} bzw. M_{TR_B} wird über den Motorsteckverbinder 4 eine elektrische Verbindung zu dem Antriebsmotor hergestellt und der mit einem Hall-Sensor ausgestattete, fingerartige Leiterplattenabschnitt 30A bzw. 30B in das Motorgehäuse der Antriebseinheit M_{TR_A} bzw. M_{TR_B} eingeführt.

Während sich die beiden in den Figuren 10 und 11 dargestellten Antriebseinheiten M_{TR_A} und M_{TR_B} lediglich dadurch unterscheiden, auf welcher Seite eines Kraftfahrzeugs sie in einem Trockenraum untergebracht werden müssen und somit ein übereinstimmendes Gehäuse 1 an beiden Antriebseinheiten M_{TR_A}, M_{TR_B} fixierbar ist, muss ein Gehäuse für eine Antriebseinheit für einen Nassraum innerhalb des Kraftfahrzeugs regelmäßig konstruktiv auf eine andere Art und Weise ausgebildet sein. So stellen die Antriebseinheiten M_{TR_A} und M_{TR_B} der Figuren 10 und 11 eine erste Art von Antriebseinheiten dar, die mit einem Gehäuse 1 einer ersten Art kombinierbar sind.

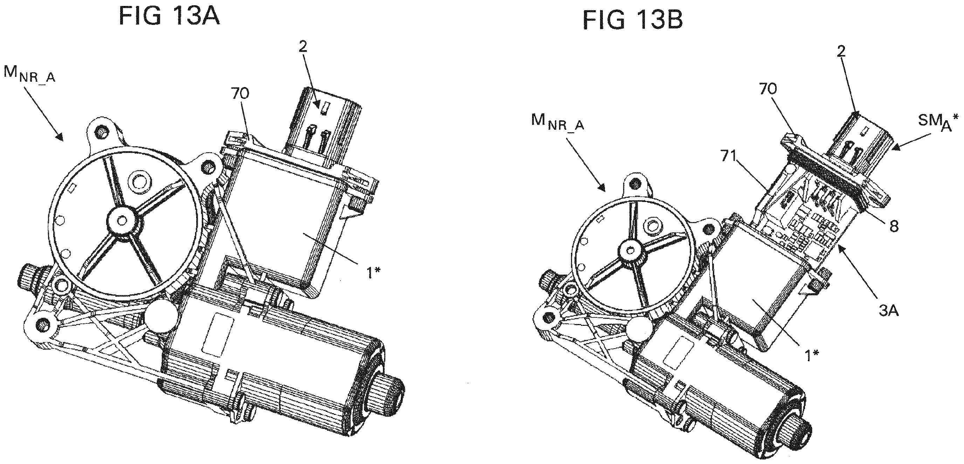

Demgegenüber ist für die Unterbringung in einem Nassraum eine Antriebseinheit M_{NR_A} (für eine linke Fahrzeugseite) einer zweiten Art, wie sie beispielhaft in den Figuren 13A und 13B gezeigt ist. Diese Antriebseinheit M_{NR_A} ist mit einem Gehäuse 1* einer zweiten Art kombiniert, in dem die auf einer Leiterplatte 3A angeordneten elektronischen Bauelemente 6 stärker geschützt gegenüber eindringender Feuchtigkeit untergebracht werden können. Das Gehäuse 1* weist hierfür eine Einführöffnung auf, über die ein Steuergerätemodul SM_{A}* in das bereits montierte Gehäuse 1* einführbar ist und die dichtend verschlossen werden kann. Ein Gehäuse 1* einer zweiten Art unterscheidet sich somit vorliegend konstruktiv von einem Gehäuse 1 entsprechend den zuvor erläuterten Figuren beispielsweise dadurch, dass ein solches Gehäuse 1* einer zweiten Art ein das Gehäuse 1* dichtend verschließendes Deckelelement aufweist, der das Gehäuse 1* verschließt, wenn das entsprechende Steuergerätemodul SM_{A}* darin platziert wurde.

Bisher war es unter anderem bekannt, unterschiedliche Leiterplatten für Steuergerätemodule für einen Trockenraum einerseits und für Steuergerätemodule für einen Nassraum andererseits zu verwenden. In der vorliegenden Ausführungsvariante werden demgegenüber in einem Bausatz lediglich zwei Typen von Leiterplatten 3A und 3B für die unterschiedlichen Fahrzeuglängsseiten (rechts oder links) bereitgestellt - gegebenenfalls in funktionell unterschiedlichen Ausstattungsvariante, ohne hierbei aber von der geometrischen Grundform der Leiterplatte 3A, 3B oder vorzugsweise von dem jeweiligen Leiterplattenlayout abzuweichen. Die Leiterplatten 3A, 3B werden darüber hinaus auch stets mit einer übereinstimmenden zur Verfügung gestellten Steckverbindereinheit 2 verbunden. Für die Montage einer Steuerungsvorrichtung wird nur unterschieden, ob das herzustellende Steuergerätemodul letztlich in einem Gehäuse 1 einer ersten Art oder in einem Gehäuse 1* einer zweiten Art zu platzieren ist.

Im Rahmen der Montage wird nun wahlweise die vorgefertigte Steckverbindereinheit 2, die beispielhaft in den Figuren 5A und 5B gezeigt ist, nur mit der Leiterplatte 3A verbunden, um ein Steuergerätemodul SM_{A} für eine bestimmte Seite des Kraftfahrzeugs und für ein in einem Trockenraum anzuordnendes Gehäuse 1 bereitzustellen, oder die Steckverbindereinheit 2 wird als vorgefertigtes Bauteil verwendet, an das eine zusätzliche Befestigungsstruktur 7 angeformt und die anschließend mit der Leiterplatte 3A verbunden wird, um ein Steuergerätemodul SM_{A}* bereitzustellen, das zwar für dieselbe Seite des Kraftfahrzeugs, aber für ein in einem Nassraum anzuordnendes Gehäuse 1* geeignet ist. Die Steckverbindereinheit 2 wird somit bei Bedarf um die Befestigungsstruktur 7 erweitert, um ein alternatives Steuergerätemodul SM_{A}* desselben Typs (also für dieselbe Kraftfahrzeugseite), aber für ein konstruktiv verschiedenartiges Gehäuse 1* für den Nassraum herzustellen.

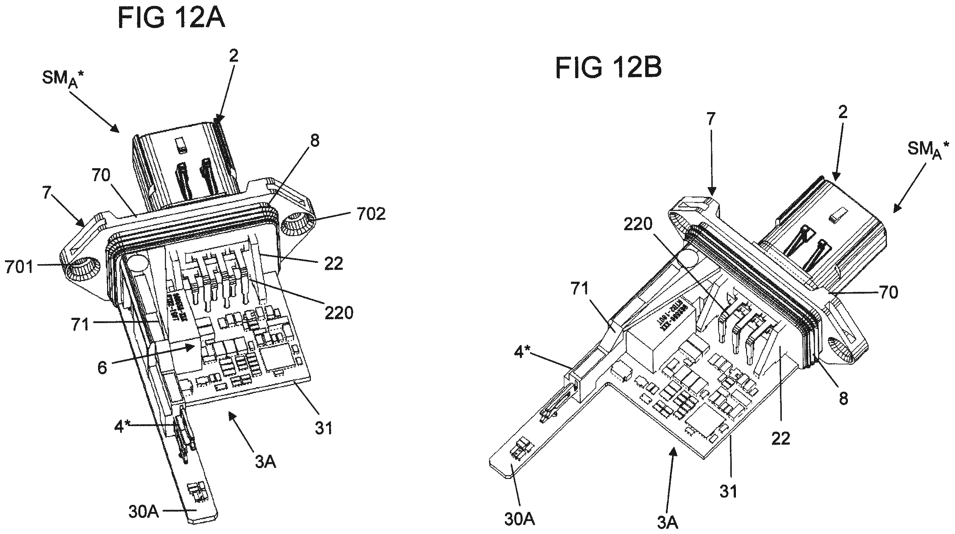

In den Figuren 12A und 12B ist ein solches alternatives Steuergerätemodul SM_{A}* veranschaulicht. Bei diesem dient die vorgefertigte Steckverbindereinheit 2 als Vorspritzling, an den die Befestigungsstruktur 7 im Rahmen eines Spritzgussverfahrens angespritzt wird. Die Befestigungsstruktur 7 bildet hier unter anderem eine Abdeckung 70 aus, über die das Gehäuse 1* entsprechend den Figuren 13A und 13B verschließbar ist. Ferner ist an dieser Abdeckung 70 ein Dichtelement 8 aus einer Weichkomponente angeformt. Dieses Dichtelement 8 gewährleistet, dass mit der Abdeckung 70 das Gehäuse 1* gegenüber einem umgebenden Außenraum dichtend verschlossen wird.

Des Weiteren sind an der Befestigungsstruktur 7 zwei zusätzliche Befestigungsbereiche in Form von Durchgangsöffnungen 701 und 702 ausgebildet. Diese Durchgangsöffnungen 701, 702 dienen der Fixierung des in das Gehäuse 1* eingesetzten Steuergerätemoduls SM_{A}* an dem Gehäuse 1*. So können beispielsweise zusätzliche Befestigungselemente, wie Schrauben an den Durchgangsöffnungen 701, 702 eingreifen, um die Abdeckung 70 dichtend an dem Gehäuse 1* zu fixieren.

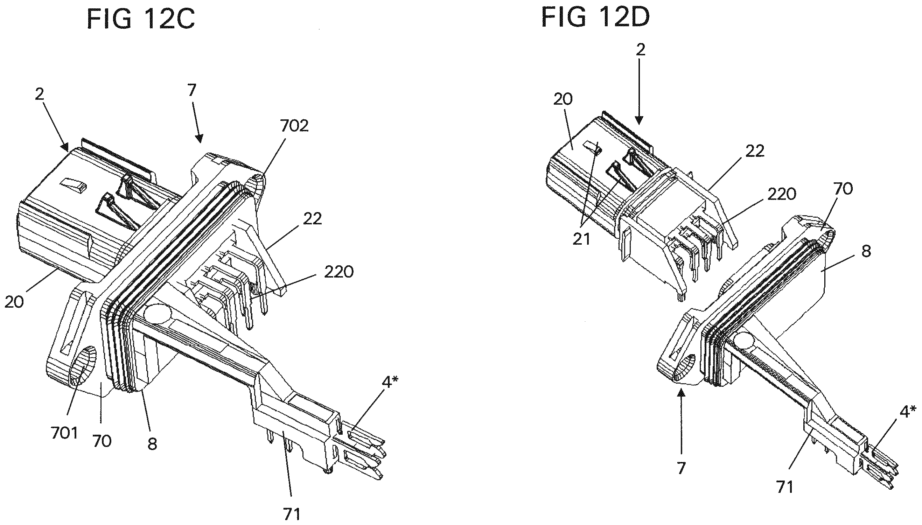

Wie insbesondere in den Einzelansichten der Figuren 12C und 12D dargestellt ist, bildet die angeformte Befestigungsstruktur 7 einen Trägerabschnitt 71 aus, der im Anschluss an die Anformung der Befestigungsstruktur 7 mit der Leiterplatte 3A verbunden wird. Darüber hinaus ist in dem vorliegenden Ausführungsbeispiel an dem Trägerabschnitt 71 auch bereits ein Motorsteckverbinder 4* vorgesehen. Die der elektrischen Verbindung des Motorsteckverbinders 4* mit der Leiterplatte 3A dienenden Leiter sind demgemäß bereits in den Trägerabschnitt 71 eingebettet.

Zusammenfassend wird vorliegend die Befestigungsstruktur 7, mit ihrer Abdeckung 70, dem Dichtelement 8 und dem Trägerabschnitt 71, zunächst an der als Vorspritzling dienenden Steckverbindereinheit 2 angeformt. Im Anschluss erfolgt dann die Verbindung der Steckverbindereinheit 2 und der Befestigungsstruktur 7 mit der Leiterplatte 3A. Das derart hergestellte Steuergerätemodul SM_{A}* kann dann über eine Einführöffnung des Gehäuses 1* in das Gehäuse 1* eingesetzt werden. Dabei verschließt die Abdeckung 70 des Steuergerätemoduls SM_{A}* diese Einführöffnung vollständig, wenn das Steuergerätemodul SM_{A}* bestimmungsgemäß an dem Gehäuse 1* angeordnet ist.

Im vorliegenden Fall ist das Gehäuse 1* zudem an der Antriebseinheit M_{NR_A} ausgeformt, so dass der fingerartig vorstehende Leiterplattenabschnitt 30A und der Motorsteckverbinder 4* automatisch bestimmungsgemäß in die Antriebseinheit M_{NR_A} eingeführt bzw. mit diesem elektrisch verbunden werden, wenn das Steuergerätemodul SM_{A}* in das Gehäuse 1* eingesetzt wird.

In einem Bausatz, der sowohl für die Montage einer Steuerungsvorrichtung für eine in einem Trockenraum einzusetzende Antriebseinheit M_{TR_A}, M_{TR_B} als auch für die Montage einer Steuerungsvorrichtung für eine in einem Nassraum einzusetzende Antriebseinheit M_{NR_A} dient, sind somit möglichst viele übereinstimmende Komponenten bereitgestellt, wie die vorgefertigte Steckverbindereinheit 2, Leiterplatten 3A und 3B (mit gegebenenfalls lediglich unterschiedlicher Bestückung, aber ansonsten übereinstimmendem Layout zur Anordnung auf denselben Kraftfahrzeugseiten), sowie lediglich zwei verschiedenartige Gehäuse 1, 1*. Im Ergebnis muss so nur eine geringe Anzahl von unterschiedlichen vorgefertigten Komponenten zur Verfügung gestellt werden, um im Fertigungsprozess unterschiedliche Steuergerätemodule SM_{A}, SM_{B}, SM_{A}* bzw. damit gebildete Steuerungsvorrichtungen SG_{A}, SG_{B} herstellen zu können, die jeweils zur Steuerung einer Antriebseinheit M_{TR_A}, M_{TR_B}, M_{NR_A} eingerichtet und vorgesehen sind und sich im Hinblick darauf unterscheiden, ob sie im Nassraum oder im Trockenraum eines Kraftfahrzeugs und auf einer linken oder rechten Kraftfahrzeugseite anzuordnen sind. Hierdurch können Werkzeug-, Validierungs- und Automatisierungskosten enorm reduziert werden.

Dabei kann selbstverständlich auch vorgesehen sein, dass ein Gehäuse 1* für den Nassraum gleichfalls in Analogie zu dem Gehäuse 1 für den Trockenraum so ausgelegt ist, dass es Steuergerätemodule unterschiedlicher Typen, also für unterschiedliche Seiten des Kraftfahrzeugs aufnehmen kann.

### Bezugszeichenliste

- 1, 1*: Gehäuse
- 10: Innenraum
- 100: Aussparung
- 101, 102: Gehäuseöffnung
- 101.1, 102.1: Aussparung für Gehäuseöffnung (erstes Gehäuseteil)
- 101.2, 102.2: Aussparung für Gehäuseöffnung (zweites Gehäuseteil)
- 11: (erstes) Gehäuseteil
- 11.1, 11.2: Haltemittel für Gehäuseanbindung
- 11.3, 11.4: Gleitführung
- 110A, 110B: Halterungsabschnitt für Verschlusselement (erstes Gehäuseteil)
- 111.1 - 111.4: Verbindungsbereich (erstes Gehäuseteil)
- 12: (zweites) Gehäuseteil
- 120A, 120B: Halterungsabschnitt für Verschlusselement (zweites Gehäuseteil)
- 121.1 - 121.4: Verbindungsbereich (zweites Gehäuseteil)
- 122.1, 122.2: Auflageabschnitt
- 123A, 123B: (randseitiger) Auflageabschnitt
- 124: Steckverbinderhalterung
- 2: Steckverbindereinheit
- 20: Steckergehäuse
- 21: Haltemittel für Steckerverbindung
- 22: Schnittstellenbereich
- 220: Leiterpin
- 23: Befestigungspin
- 24: Steg (Befestigungsbereich)
- 30A, 30B: Leiterplattenabschnitt
- 3A, 3B: Leiterplatte
- 31: Basisabschnitt
- 4, 4*: Motorsteckverbinder
- 5: Verschlusselement
- 50: Sollbruchstelle
- 6: Bauelement
- 7: Befestigungsstruktur
- 70: Abdeckung
- 701, 702: Durchgangsöffnung (Befestigungsbereich)
- 71: Trägerabschnitt für Motorsteckverbinder
- 8: Dichtelement
- F_{A}, F_{B}: Freiraum
- H_{A}, H_{B}: Halterung
- I_{A}, I_{B}: Anschlussbereich
- M_{NR_A}: Antriebseinheit
- M_{TR_A}, M_{TR_B}: Antriebseinheit
- SG_{A}, SG_{B}: Steuergerät
- SM_{A}, SM_{B}, SM_{A}*: Steuergerätmodul

## Patentansprüche

1. Gehäuse für ein elektronisches Steuergerätmodul zur Steuerung einer Antriebseinheit einer Kraftfahrzeugverstelleinrichtung, insbesondere eines Fensterhebers, wobei das Steuergerätemodul zum Anschluss an die zu steuernde Antriebseinheit eingerichtet und vorgesehen ist und zur Steuerung der Antriebseinheit mindestens eine Leiterplatte umfasst, und wobei das Gehäuse zur wenigstens teilweisen Aufnahme der Leiterplatte des Steuergerätemoduls ausgebildet und vorgesehen ist und das Gehäuse (1) eine Gehäuseöffnung (101, 102) aufweist, in der ein Steckverbinder (4) zum Anschluss des Steuergerätmoduls (SM_{A}, SM_{B}) an die zu steuernde Antriebseinheit (M_{TR_A;} M_{TR_B}) derart gehalten ist, dass der Steckverbinder (4) von außerhalb des Gehäuses (1) zugänglich ist, **dadurch gekennzeichnet, dass**
- das Gehäuse (1) dazu ausgebildet und vorgesehen ist, wahlweise wenigstens die Leiterplatte (3A, 3B) eines von wenigstens zwei unterschiedlichen Typen von Steuergerätemodulen (SM_{A}, SM_{B}) mit unterschiedlichen Leiterplatten (3A, 3B) zumindest teilweise aufzunehmen, wobei ein erster Typ von Steuergerätemodul (SM_{A}) für die Steuerung einer Antriebseinheit (M_{TR_A}) auf einer ersten Seiten eines Kraftfahrzeugs eingerichtet und vorgesehen ist und ein zweiter Typ von Steuergerätemodul (SM_{B}) für die Steuerung einer Antriebseinheit (M_{TR_B}) auf einer zweiten Seite des Kraftfahrzeugs, die der ersten Seite quer zu einer Fahrzeugslängsachse gegenüberliegt, eingerichtet und vorgesehen ist, und
- die Gehäuseöffnung (101, 102) so ausgebildet ist, dass durch diese hindurch jeweils ein mit dem Steckverbinder (4) verbundener Abschnitt (30A, 30B) der Leiterplatte (3A, 3B) aus dem Gehäuses (1) heraus geführt werden kann.

2. Gehäuse nach Anspruch 1, **dadurch gekennzeichnet, dass** das Gehäuse (1) wenigstens zwei Gehäuseöffnungen (101, 102) aufweist und das Gehäuse (1) dazu ausgebildet und vorgesehen ist, wahlweise wenigstens die Leiterplatte (3A, 3B) und den mindestens einen Steckverbinder (4) der wenigstens zwei unterschiedlichen Typen von Steuergerätemodulen (SM_{A}, SM_{B}) zumindest teilweise so aufzunehmen, dass der Steckverbinder (4) eines ersten Typs von Steuergerätemodul (SM_{A}) in der einen Gehäuseöffnung (101) und der Steckverbinder (4) des zweiten Typs von Steuergerätemodul (SM_{B}) in der anderen Gehäuseöffnung (102) gehalten wird.

3. Gehäuse nach Anspruch 1 oder 2, **dadurch gekennzeichnet, dass** eine Gehäuseöffnung (101, 102) durch ein Verschlusselement (5) verschließbar ist.

4. Gehäuse nach Anspruch 3, **dadurch gekennzeichnet, dass** das Verschlusselement (5) in einer an dem Gehäuse (1) ausgebildeten Halterung (110A, 110B, 120A, 120B) formschlüssig aufgenommen werden kann, um die jeweilige Gehäuseöffnung (101; 102) zu verschließen.

5. Gehäuse nach Anspruch 3 oder 4, **dadurch gekennzeichnet, dass** das Verschlusselement (5) an einem Teil des Gehäuses (1) lösbar befestigt und zunächst von dem Teil des Gehäuses (1) vollständig entfernbar ist, um das Verschlusselement (5) zum Verschließen der jeweiligen Gehäuseöffnung (1) zu verwenden.

6. Gehäuse nach einem der vorhergehenden Ansprüche, **dadurch gekennzeichnet, dass** ein Innenraum (10) des Gehäuses (1) so dimensioniert ist, dass bei der zumindest teilweisen Aufnahme der Leiterplatte (3A; 3B) eines Steuergerätemoduls des ersten Typs (SM_{A}; SM_{B}) in einem Bereich innerhalb des Gehäuses (1) ein ungenutzter Freiraum (F_{A}; F_{B}) verbleibt und bei der zumindest teilweisen Aufnahme der Leiterplatte (3B; 3A) eines Steuergerätemoduls des zweiten Typs (SM_{B}; SM_{A}) in demselben Bereich wenigstens ein Abschnitt der Leiterplatte (3B; 3A) des Steuergerätemodul des zweiten Typs (SM_{B}; SM_{A}) angeordnet wird.

7. Gehäuse nach einem der vorhergehenden Ansprüche, **dadurch gekennzeichnet, dass** das Gehäuse (1) wenigstens zwei miteinander verbundene Gehäuseteile (11, 12) aufweist, die im verbundenen Zustand einen Innenraum (10) des Gehäuses (1) definieren, in dem die Leiterplatte (3A, 3B) eines Steuergerätemoduls (SM_{A}, SM_{B}) wenigstens teilweise aufgenommen ist.

8. Gehäuse nach einem der vorhergehenden Ansprüche, **dadurch gekennzeichnet, dass** das Gehäuse (1) symmetrisch, insbesondere spiegelsymmetrisch zu einer Symmetrieachse ausgebildet ist.

9. Bausatz für eine Steuerungsvorrichtung, mit einem Gehäuse (1) nach einem der vorhergehenden Ansprüche 1 bis 8 und mit wenigstens zwei unterschiedlichen elektronischen Steuergerätemodulen eines ersten und eines zweiten Typs (SM_{A}, SM_{B}), die jeweils zum Anschluss an eine zu steuernde Antriebseinheit (M_{TR_A}, M_{TR_B}) eingerichtet und vorgesehen sind und zur Steuerung der Antriebseinheit (M_{TR_A}, M_{TR_B}) mindestens eine Leiterplatte (3A, 3B) umfassen, wobei zur Montage einer Steuerungsvorrichtung (SG_{A}, SG_{B}) wahlweise ein Steuergerätemodul des ersten oder des zweiten Typs (SM_{A}, SM_{B}) verwendbar ist, und wobei das Gehäuse (1) dazu ausgebildet und vorgesehen ist, wahlweise die Leiterplatte (3A, 3B) des einen oder des anderen Typs von Steuergerätemodul (SM_{A}, SM_{B}) zumindest teilweise aufzunehmen.

10. Bausatz nach Anspruch 9, **dadurch gekennzeichnet, dass** die wenigstens zwei unterschiedlichen Typen von Steuergerätemodulen (SM_{A}, SM_{B}) Leiterplatten (3A, 3B) aufweisen, die im Wesentlichen dieselben geometrischen Abmessungen aufweisen.

11. Bausatz nach Anspruch 10, **dadurch gekennzeichnet, dass** die Leiterplatten (3A, 3B) der Steuergerätemodule (SM_{A}, SM_{B}) im unbestücktem Zustand zueinander symmetrisch ausgebildet sind, insbesondere spiegelsymmetrisch zu einer Symmetrieachse, die zwischen zwei nebeneinander angeordneten Leiterplatten (3A, 3B) verläuft.

12. Bausatz nach einem der Ansprüche 9 bis 11, **dadurch gekennzeichnet, dass**
- der Bausatz eine vorgefertigte Steckverbindereinheit (2) mit einem Steckverbinder und einem Schnittstellenbereich (22) zur elektrischen Verbindung des Steckverbinders (2) mit einer Leiterplatte (3A, 3B) aufweist und die Steckverbindereinheit (2) sowohl zur Herstellung des Steuergerätemoduls des ersten Typs (SM_{A}) als auch zur Herstellung des Steuergerätemoduls des zweiten Typs (SM_{B}) verwendbar ist, und/oder
- die Leiterplatten (3A, 3B) jeweils einen Abschnitt (30A, 30B) aufweisen, der im zusammengebauten Zustand der Steuerungsvorrichtung (SG_{A}, SG_{B}) durch eine Gehäuseöffnung (101, 102) hindurch aus dem Gehäuse (1) heraus geführt ist.

13. Bausatz nach Anspruch 12, **dadurch gekennzeichnet, dass** an dem herausgeführten Abschnitt (30A, 30B) wenigstens ein Sensorelement, insbesondere ein Hall-Sensor angeordnet ist.

14. Verfahren zur Montage einer Steuerungsvorrichtung mit einem Bausatz nach einem der Ansprüche 9 bis 13, wobei wahlweise ein Steuergerätemodul des ersten oder des zweiten Typs (SM_{A}, SM_{B}) verwendet und an das Gehäuse (1) montiert wird, so dass stets wenigstens die Leiterplatte (3A, 3B) des jeweiligen Steuergerätemoduls (SM_{A}, SM_{B}) zumindest teilweise in dem Gehäuse (1) aufgenommen ist.

## Claims

1. A housing for an electronic controller module for controlling a drive unit of a motor vehicle adjusting device, in particular of a window lifter, wherein the controller module is equipped and provided for connection to the drive unit to be controlled and for controlling the drive unit comprises at least one printed circuit board, and wherein the housing is formed and provided for at least partly accommodating the printed circuit board of the controller module and the housing (1) includes a housing opening (101, 102) in which a connector (4) for connection of the controller module (SM_{A}, SM_{B}) to the drive unit (M_{TR_A;} M_{TR_B}) to be controlled is held such that the connector (4) is accessible from outside the housing (1), **characterized in that**
- the housing (1) is formed and provided to selectively at least partly accommodate the printed circuit board (3A, 3B) of one of at least two different types of controller modules (SM_{A}, SM_{B}) with different printed circuit boards (3A, 3B), wherein a first type of controller module (SM_{A}) is equipped and provided for controlling a drive unit (M_{TR_A}) on a first side of a motor vehicle, and a second type of controller module (SM_{B}) is equipped and provided for controlling a drive unit (M_{TR_B}) on a second side of the motor vehicle, which is located opposite the first side transversely to a longitudinal vehicle axis, and
- the housing opening (101, 102) is formed such that through the same one portion (30A, 30B) each of the printed circuit board (3A, 3B) connected with the connector (4) can be led out of the housing (1).

2. The housing according to claim 1, **characterized in that** the housing (1) includes at least two housing openings (101, 102) and the housing (1) is formed and provided to selectively at least partly accommodate at least the printed circuit board (3A, 3B) and the at least one connector (4) of the two different types of controller modules (SM_{A}, SM_{B}) such that the connector (4) of a first type of controller module (SM_{A}) is held in the one housing opening (101) and the connector (4) of the second type of controller module (SM_{B}) is held in the other housing opening (102).

3. The housing according to any of claims 1 or 2, **characterized in that** a housing opening (101, 102) can be closed by a closure element (5).

4. The housing according to claim 3, **characterized in that** the closure element (5) can positively be accommodated in a holder (110A, 110B, 120A, 120B) formed at the housing (1), in order to close the respective housing opening (101; 102).

5. The housing according to claim 3 or 4, **characterized in that** the closure element (5) is releasably attached to a part of the housing (1) and initially can completely be removed from that part of the housing (1), in order to use the closure element (5) for closing the respective housing opening (1).

6. The housing according to any of the preceding claims, **characterized in that** an interior space (10) of the housing (1) is dimensioned such that during the at least partial accommodation of the printed circuit board (3A; 3B) of a controller module of the first type (SM_{A}; SM_{B}) in a region inside the housing (1) an unused free space (F_{A}; F_{B}) is left and during the at least partial accommodation of the printed circuit board (3A; 3B) of a controller module of the second type (SM_{B}; SM_{A}) in the same region at least one portion of the printed circuit board (3B; 3A) of the controller module of the second type (SM_{B}; SM_{A}) is arranged.

7. The housing according to any of the preceding claims, **characterized in that** the housing (1) includes at least two housing parts (11, 12) connected with each other, which in the connected condition define an interior space (10) of the housing (1), in which the printed circuit board (3A, 3B) of a controller module (SM_{A}, SM_{B}) is at least partly accommodated.

8. The housing according to any of the preceding claims, **characterized in that** the housing (1) is formed symmetrically, in particular mirror-symmetrically to an axis of symmetry.

9. A construction kit for a control apparatus, comprising a housing (1) according to any of the preceding claims 1 to 8 and comprising at least two different electronic controller modules of a first and a second type (SM_{A}, SM_{B}), which each are equipped and provided for connection to a drive unit (M_{TR_A}, M_{TR_B}) to be controlled and for controlling the drive unit (M_{TR_A}, M_{TR_B}) comprise at least one printed circuit board (3A, 3B), wherein for the assembly of a control apparatus (SG_{A}, SG_{B}) a controller module of the first or the second type (SM_{A}, SM_{B}) can be used selectively, and wherein the housing (1) is formed and provided to selectively at least partly accommodate the printed circuit board (3A, 3B) of the one or the other type of controller module (SM_{A}, SM_{B}).

10. The construction kit according to claim 9, **characterized in that** the at least two different types of controller modules (SM_{A}, SM_{B}) include printed circuit boards (3A, 3B) which substantially have the same geometric dimensions.

11. The construction kit according to claim 10, **characterized in that** in the bare condition the printed circuit boards (3A, 3B) of the controller modules (SM_{A}, SM_{B}) are formed symmetrical to each other, in particular mirror-symmetrical to an axis of symmetry which extends between two printed circuit boards (3A, 3B) arranged one beside the other.

12. The construction kit according to any of claims 9 to 11, **characterized in that**
- the construction kit includes a prefabricated connector unit (2) with a connector and an interface region (22) for electrically connecting the connector (2) with a printed circuit board (3A, 3B) and the connector unit (2) can be used both for manufacturing the controller module of the first type (SM_{A}) and for manufacturing the controller module of the second type (SM_{B}), and/or
- the printed circuit boards (3A, 3B) each include a portion (30A, 30B) which in the assembled condition of the control apparatus (SG_{A}, SG_{B}) is guided through a housing opening (101, 102) out of the housing (1).

13. The construction kit according to claim 12, **characterized in that** at the portion (30A, 30B) guided out at least one sensor element, in particular a Hall sensor is arranged.

14. A method for the assembly of a control apparatus with a construction kit according to any of claims 9 to 13, wherein selectively a controller module of the first or the second type (SM_{A}, SM_{B}) is used and mounted to the housing (1), so that always at least the printed circuit board (3A, 3B) of the respective controller module (SM_{A}, SM_{B}) is at least partly accommodated in the housing (1).

## Revendications

1. Boîtier pour un module d'appareil de commande électronique pour la commande d'une unité d'entraînement d'un système de réglage de véhicule automobile, en particulier d'une manette d'ouverture de fenêtre, dans lequel le module d'appareil de commande est conçu et prévu pour le raccordement à l'unité d'entraînement à commander et comprend au moins une carte de circuit imprimé pour la commande de l'unité d'entraînement, et dans lequel le boîtier est réalisé et prévu pour un logement au moins en partie de la carte de circuit imprimé du module d'appareil de commande et le boîtier (1) présente une ouverture de boîtier (101, 102) dans laquelle un connecteur enfichable (4) pour le raccordement du module d'appareil de commande (SM_{A}, SM_{B}) à l'unité d'entraînement (M_{TR_A} ; M_{TR_B}) à commander est maintenu de telle sorte que le connecteur enfichable (4) est accessible depuis l'extérieur du boîtier (1), **caractérisé en ce que**
- le boîtier (1) est réalisé et prévu pour loger au moins en partie sélectivement au moins la carte de circuit imprimé (3A, 3B) d'un parmi au moins deux types différents de modules d'appareil de commande (SM_{A}, SM_{B}) avec différentes cartes de circuit imprimé (3A, 3B), dans lequel un premier type de module d'appareil de commande (SM_{A}) pour la commande d'une unité d'entraînement (M_{TR_A}) est conçu et prévu sur un premier côté d'un véhicule automobile et un deuxième type de module d'appareil de commande (SM_{B}) est conçu et prévu pour la commande d'une unité d'entraînement (M_{TR_B}) sur un deuxième côté du véhicule automobile qui fait face au premier côté transversalement à un axe longitudinal de véhicule, et
- l'ouverture de boîtier (101, 102) est réalisée de sorte que, à travers celle-ci, respectivement une section (30A, 30B) reliée au connecteur enfichable (4) de la carte de circuit imprimé (3A, 3B) puisse être guidée hors du boîtier (1).

2. Boîtier selon la revendication 1, **caractérisé en ce que** le boîtier (1) présente au moins deux ouvertures de boîtier (101, 102) et le boîtier (1) est réalisé et prévu pour loger au moins en partie sélectivement au moins la carte de circuit imprimé (3A, 3B) et l'au moins un connecteur enfichable (4) d'un parmi au moins des deux types différents de modules d'appareil de commande (SM_{A}, SM_{B}) de sorte que le connecteur enfichable (4) d'un premier type de module d'appareil de commande (SM_{A}) soit maintenu dans l'une ouverture de boîtier (101) et le connecteur enfichable (4) du deuxième type de module d'appareil de commande (SM_{B}) soit maintenu dans l'autre ouverture de boîtier (102).

3. Boîtier selon la revendication 1 ou 2, **caractérisé en ce qu'**une ouverture de boîtier (101, 102) peut être fermée par un élément de fermeture (5).

4. Boîtier selon la revendication 3, **caractérisé en ce que** l'élément de fermeture (5) peut être logé par complémentarité de formes dans un support (110A, 110B, 120A, 120B) réalisé au niveau du boîtier (1) pour fermer l'ouverture de boîtier (101 ; 102) respective.

5. Boîtier selon la revendication 3 ou 4, **caractérisé en ce que** l'élément de fermeture (5) est fixé de manière amovible à une partie du boîtier (1) et ensuite peut être entièrement retiré de la partie du boîtier (1) pour utiliser l'élément de fermeture (5) pour la fermeture de l'ouverture de boîtier (1) respective.

6. Boîtier selon l'une des revendications précédentes, **caractérisé en ce qu'**un espace interne (10) du boîtier (1) est dimensionné de sorte que lors du logement au moins en partie de la carte de circuit imprimé (3A ; 3B) d'un module d'appareil de commande du premier type (SM_{A}, SM_{B}) dans une zone à l'intérieur du boîtier (1), un espace libre (F_{A} ; F_{B}) inutilisé subsiste et lors du logement au moins en partie de la carte de circuit imprimé (3B ; 3A) d'un module d'appareil de commande du deuxième type (SM_{B} ; SM_{A}) dans la même zone, au moins une section de la carte de circuit imprimé (3B ; 3A) du module d'appareil de commande du deuxième type (SM_{B} ; SM_{A}) soit disposée.

7. Boîtier selon l'une des revendications précédentes, **caractérisé en ce que** le boîtier (1) présente au moins deux parties de boîtier (11, 12) reliées entre elles, qui définissent à l'état lié un espace interne (10) du boîtier (1), dans lequel la carte de circuit imprimé (3A, 3B) d'un module d'appareil de commande (SM_{A}, SM_{B}) est logée au moins en partie.

8. Boîtier selon l'une des revendications précédentes, **caractérisé en ce que** le boîtier (1) est réalisé de manière symétrique, en particulier de manière symétrique par réflexion par rapport à un axe de symétrie.

9. Kit pour un dispositif de commande, avec un boîtier (1) selon l'une des revendications précédentes 1 à 8 et avec au moins deux modules d'appareil de commande électroniques différents d'un premier et d'un deuxième type (SM_{A}, SM_{B}) qui sont respectivement conçus et prévus pour le raccordement à une unité d'entraînement (M_{TR_A}, M_{TR_B}) à commander et comprennent pour la commande de l'unité d'entraînement (M_{TR_A}, M_{TR_B}) au moins une carte de circuit imprimé (3A, 3B), dans lequel pour le montage d'un dispositif de commande (SG_{A}, SG_{B}) un module d'appareil de commande du premier ou du deuxième type (SM_{A}, SM_{B}) peut être utilisé sélectivement, et dans lequel le boîtier (1) est réalisé et prévu pour loger au moins en partie sélectivement la carte de circuit imprimé (3A, 3B) de l'un ou de l'autre type de module d'appareil de commande (SM_{A}, SM_{B}).

10. Kit selon la revendication 9, **caractérisé en ce que** les au moins deux types différents de modules d'appareil de commande (SM_{A}, SM_{B}) présentent des cartes de circuit imprimé (3A, 3B) qui présentent sensiblement les mêmes dimensions géométriques.

11. Kit selon la revendication 10, **caractérisé en ce que** les cartes de circuit imprimé (3A, 3B) des modules d'appareil de commande (SM_{A}, SM_{B}) sont réalisées à l'état non équipé de manière symétrique l'une par rapport à l'autre, en particulier de manière symétrique par réflexion par rapport à un axe de symétrie qui s'étend entre deux cartes de circuit imprimé (3A, 3B) disposées l'une à côté de l'autre.

12. Kit selon l'une des revendications 9 à 11, **caractérisé en ce que**
- le kit présente une unité de connecteur enfichable (2) préfabriquée avec un connecteur enfichable et une zone d'interfaçage (22) pour la liaison électrique du connecteur enfichable (2) avec une carte de circuit imprimé (3A, 3B) et l'unité de connecteur enfichable (2) peut être utilisée aussi bien pour la fabrication du module d'appareil de commande du premier type (SM_{A}) que pour la fabrication du module d'appareil de commande du deuxième type (SM_{B}), et/ou
- les cartes de circuit imprimé (3A, 3B) présentent respectivement une section (30A, 30B) qui, à l'état assemblé du dispositif de commande (SG_{A}, SG_{B}), est guidée hors du boîtier (1) à travers une ouverture de boîtier (101, 102).

13. Kit selon la revendication 12, **caractérisé en ce que**, au niveau de la section (30A, 30B) sortie, au moins un élément capteur, en particulier un capteur à effet Hall, est disposé.

14. Procédé pour le montage d'un dispositif de commande avec un kit selon l'une des revendications 9 à 13, dans lequel un module d'appareil de commande du premier ou du deuxième type (SM_{A}, SM_{B}) est utilisé sélectivement et est monté au niveau du boîtier (1) de sorte qu'au moins la carte de circuit imprimé (3A, 3B) du module d'appareil de commande (SM_{A}, SM_{B}) respectif soit toujours au moins en partie logée dans le boîtier (1).
